# FASCICULE DE BREVET EUROPEEN

(11) **EP 3 965 154 B1**
(45) Date de publication et mention de la délivrance du brevet: **02.09.2026**
(21) Numéro de dépôt: 21204030.7
(22) Date de dépôt: 03.07.2018
(51) Int. Cl.: G09F 9/33, H10W 90/00, H10H 29/24, H10H 29/85

(54) **DISPOSITIF D'AFFICHAGE A LEDS**
ANZEIGEVORRICHTUNG MIT LEDS
DISPLAY DEVICE WITH LEDS

(30) Priorité: 04.07.2017 FR 1756310
(43) Date de publication de la demande: 09.03.2022
(62) Numéro(s) de document de la (des) demande(s) initiale(s) en application de l'article 76 CBE: 18749022.2 / 3 649 672
(73) Titulaire: Commissariat à l'Energie Atomique et aux Energies Alternatives, 75015 Paris (FR)
(72) Inventeur: ROBIN,, Ivan-Christophe, 38000 GRENOBLE (FR); DUPONT,, Bertrand, 38360 SASSENAGE (FR); CAPLET,, Stéphane, 38360 SASSENAGE (FR); DE FOUCAULD,, Emeric, 38500 COUBLEVIE (FR); ROSSINI,, Umberto, 38500 COUBLEVIE (FR); TCHELNOKOV,, Alexei, 38240 MEYLAN (FR); TEMPLIER,, François, 38054 GRENOBLE CEDEX 9 (FR)
(74) Mandataire: Santarelli

(56) Documents cités:
- WO-A1-2018/091657
- WO-A2-2016/046283
- US-A1- 2015 249 069
- US-A1- 2018 061 814

## Description

### DOMAINE TECHNIQUE ET ART ANTÉRIEUR

Le domaine de l'invention concerne les dispositifs d'affichage ou de projection d'image. Il concerne notamment la réalisation d'un écran comprenant des LEDs ou des micro-LEDs (µLEDs) avantageusement réalisées avec du GaN.

La grande majorité des écrans actuels sont réalisés avec des cristaux liquides couplés à un rétro-éclairage et sont appelés écran LCD (pour « Liquid Crystal Display », ou écran à cristaux liquides). Une matrice de cristaux liquides d'un tel écran est pilotée par des TFT (pour « Thin Film Transistor », ou transistor en couche mince).

Une autre technologie d'écrans plus efficaces est la technologie OLEDs, ou diodes électroluminescentes organiques. Le principe de commande des pixels est similaire à celui utilisé dans le cas d'un écran LCD (circuit de commande réalisé en technologie TFT).

Il est également possible d'utiliser des micro-LEDs (ou µLEDs) comprenant par exemple une structure à base de GaN/InGaN. Ces µLEDs permettent d'avoir une consommation réduite (efficacité de µLEDs GaN/InGaN supérieure à 60 %) par rapport aux écrans LCD et OLED. Ces µLEDs sont compatibles avec de fortes densités de courant, ce qui permet d'avoir de fortes luminances, typiquement de 10⁶ cd/m².

Le document FR 3 044 467 décrit un procédé de fabrication d'un écran par assemblage de micro-puces constituées de µLEDs et de leur électronique de commande. Avec ce procédé, l'électronique de commande peut être réalisée en technologie bulk et non en technologie TFT. Ce procédé a toutefois pour inconvénient de devoir réaliser un report très précis des micro-puces, qui comportent chacune quatre connexions, sur un réseau d'interconnexions, ce qui est compliqué à réaliser étant donné la précision requise. La durée nécessaire pour réaliser ce report est également très importante en raison du nombre de µLEDs devant être reportées. WO 2018/091657 A1 décrit des modules LEDs contrôlables par signaux RF. US 2015/249069 A1 décrit un dispositif d'affichage passif, avec possible disposition non-déterministique des modules LEDs entre deux électrodes de contact d'une zone d'affichage.

### EXPOSÉ DE L'INVENTION

Un but de la présente invention est de proposer un dispositif d'affichage dont l'architecture autorise un relâchement des contraintes relatives au report et au positionnement des LEDs par rapport aux interconnexions auxquelles les LEDs sont reliées.

Pour cela, il est proposé un dispositif d'affichage selon la revendication 1.

Dans un tel dispositif, étant donné les dimensions importantes de la surface d'accueil par rapport à celles des plots d'alimentation, il n'est pas nécessaire de réaliser un positionnement précis des modules LED sur la surface d'accueil du premier élément conducteur. Différentes manières de reporter les modules LED sur cette surface d'accueil est donc envisageable, comme par exemple réaliser une disposition aléatoire des modules LED sur la surface d'accueil. Il n'est pas nécessaire de réaliser un alignement des modules pixels vis-à-vis des éléments conducteurs auxquels les modules LED sont reliés électriquement.

Les modules LED peuvent être positionnés ou reportés sur la surface d'accueil du premier élément conducteur de manière non déterministe. Un positionnement ou report non déterministe signifie ici sensiblement aléatoire. Un report non - déterministe, peut ainsi conduire à une densité variable, et donc non uniforme, des modules LED sur un support. En outre, la densité de modules LED à un endroit donné ne pourra souvent pas être prédéterminée à l'avance et sera par exemple dictée par une loi de probabilité statistique de type loi de Poisson.

Les modules LED peuvent être positionnés ou reportés sur la surface d'accueil du premier élément conducteur de manière non contrainte ou dé-contrainte. Un positionnement ou report non-contraint, ou dé-contraint, signifie que les plots conducteurs d'alimentation des modules LED ont des surfaces de contact de dimensions inférieures à celles des surfaces conductrices d'accueil du support sur lequel sont reportés les modules LED, par exemple avec un rapport au moins égal à 2 ou au moins égal à 5, de sorte que la précision de positionnement des modules LED par le procédé de positionnement peut avoir une précision relâchée, voire très relâchée, le module LED pouvant être positionné à différents endroits de la surface d'accueil, sans qu'il soit nécessaire d'assurer un centrage des plots du module LED sur les surfaces conductrices d'accueil. Dans ce cas, la densité de modules LED pourra être sensiblement uniforme pour les différentes surfaces conductrices d'accueil, mais le positionnement des LED sur une surface d'accueil pourra fluctuer et on pourra ainsi parlé de positionnement pseudo-aléatoire sur les surfaces conductrices d'accueil.

Par ailleurs l'orientation des modules lors de leur report pourra être aléatoire ou non, selon que l'on utilise ou pas une technique de pré-orientation des modules LED avant ou pendant l'opération de report sur le support.

Le terme LED est utilisé pour désigner une LED ou une µLED.

Un rapport entre les dimensions de la surface d'accueil du premier élément conducteur et celles de la surface de connexion d'un plot d'alimentation électrique d'un module LED, dans le plan formé à l'interface de la surface d'accueil et de la surface de connexion, est supérieur ou égal à 2, ou supérieur ou égal à 5.

La surface d'accueil du premier élément conducteur correspond à l'ensemble de la surface de matériau conducteur du premier élément conducteur qui peut servir pour réaliser le contact électrique avec les plots d'alimentation électrique des modules LED. Un matériau conducteur qui ne pourrait pas servir à former la connexion électrique avec les modules LED ne fait pas partie de cette surface d'accueil.

Les modules LED peuvent être répartis de manière aléatoire ou quasi-aléatoire sur la surface d'accueil du premier élément conducteur, le dispositif pouvant résulter de la mise en œuvre du procédé décrit ci-dessous.

Les modules LED peuvent être répartis de manière aléatoire, de sorte que la densité de modules LED sur la surface d'accueil est non uniforme.

Le rapport de dimensions entre la surface d'accueil du premier élément conducteur et la surface de connexion d'un plot d'alimentation d'un des modules LED est supérieur ou égal à 2, ou supérieur ou égal à 5.

Chaque module LED peut comporter en outre un circuit de commande de la LED dudit module LED, le circuit de commande étant apte à délivrer, sur une des couches de la jonction p-n de la LED, un signal représentatif du signal lumineux destiné à être émis par la LED.

Chacun des premier et deuxième éléments conducteurs d'alimentation électrique peut comporter plusieurs pistes conductrices s'étendant sensiblement parallèlement les unes des autres, les pistes conductrices du premier élément conducteur d'alimentation électrique s'étendant sensiblement perpendiculairement aux pistes conductrices du deuxième élément conducteur d'alimentation électrique. Dans ce cas, la région correspondant à la superposition d'une des pistes conductrices du premier élément conducteur avec une des pistes conductrices du deuxième élément conducteur peut former une zone pixel d'affichage dans laquelle le ou les modules LED appartenant à cette zone d'affichage sont destinés à réaliser l'affichage d'un point lumineux du dispositif, et forment par exemple un pixel du dispositif d'affichage.

Chacun des premier et deuxième éléments conducteurs d'alimentation électrique peut comporter un unique plan électriquement conducteur, ou une unique couche électriquement conductrice.

Chaque module LED peut comporter deux LED disposées tête-bêche l'une à côté de l'autre.

Le dispositif d'affichage comporte en outre:
- un plan d'affichage comprenant plusieurs zones pixel d'affichage, chaque zone pixel d'affichage comprenant au moins un des modules LED et un dispositif de contrôle dudit au moins un des modules LED de ladite zone pixel d'affichage en fonction d'un signal de commande de ladite zone pixel d'affichage destiné à être reçu par le dispositif de contrôle ;
- une interface d'entrée/sortie du dispositif d'affichage, apte à recevoir un signal d'image destinée à être affichée sur le plan d'affichage et comprenant au moins une unité de commande destinée à délivrer les signaux de commande des zones pixel d'affichage ;
dans lequel :
- l'unité de commande est reliée à au moins une première antenne apte à émettre par ondes RF les signaux de commande des zones pixel d'affichage ;
- chaque dispositif de contrôle comprend au moins une deuxième antenne couplée à un circuit de traitement de signal RF et est apte à recevoir le signal de commande de la zone pixel d'affichage associée et à commander ledit au moins un des modules LED de la zone pixel d'affichage en fonction du signal de commande reçu pour émettre un signal lumineux correspondant à une partie du signal image associée à ladite zone pixel d'affichage.

Dans un tel dispositif d'affichage, formant par exemple un écran à µLED, les dispositifs de contrôle qui commandent les modules LED ne sont plus liés de manière filaire à la ou aux unités de commande qui traitent le signal d'image reçu par le dispositif d'affichage. Une telle configuration permet de décorréler le transport des signaux d'alimentation électrique vis-à-vis des signaux de commande des modules LED, ce qui évite le transport des signaux de commande dans des éléments conducteurs pouvant avoir des dimensions importantes et engendrant des atténuations trop importantes.

En outre, cette architecture apporte une plus grande flexibilité dans l'association entre les éléments d'affichage (modules LED et dispositifs de contrôle) et les éléments de traitement de signal en amont de l'affichage (unité(s) de commande). Ainsi, il est possible de modifier aisément l'association de ces différents éléments les uns avec les autres.

Le dispositif de contrôle peut réaliser le pilotage des modules LED à partir des signaux reçus sur la deuxième antenne même lorsque les modules LED ne comportent pas de circuits de commande.

Chacun des modules LED peut comporter un dispositif de contrôle, ou chaque zone pixel d'affichage peut comporter plusieurs modules LED et un dispositif de contrôle commun relié électriquement aux modules LED de ladite zone pixel d'affichage.

Les deuxièmes antennes peuvent être disposées dans un même plan que l'un des deux éléments conducteurs d'alimentation électrique.

Chaque dispositif de contrôle peut être disposé entre les deux éléments conducteurs d'alimentation électrique et alimenté par lesdits éléments conducteurs d'alimentation électrique.

On peut ainsi mettre en œuvre un procédé d'affichage d'une image sur un dispositif d'affichage, comprenant au moins :
- une réception d'un signal d'image destinée à être affichée sur un plan d'affichage du dispositif d'affichage ;
- un traitement du signal d'image par au moins une unité de commande du dispositif d'affichage pour déterminer des signaux de commande de plusieurs zones pixel d'affichage du dispositif d'affichage telles que chaque zone pixel d'affichage comprend au moins un module LED incluant au moins une LED,
- un envoi par ondes RF des signaux de commande aux zones pixel d'affichage ;
- une réception de chaque signal de commande par un dispositif de contrôle de chaque zone pixel d'affichage ;
- une commande du module LED de chaque zone pixel d'affichage par ledit dispositif de contrôle en fonction du signal de commande reçu pour émettre un signal lumineux correspondant à une partie du signal image associée à ladite zone pixel d'affichage.

Il est également proposé un procédé de réalisation d'un dispositif d'affichage selon la revendication 10.

Lors de l'étape de report des modules LED, le positionnement des modules LED peut être réalisé de façon aléatoire ou quasi-aléatoire sur ladite au moins une surface d'accueil du premier élément conducteur.

La dispersion des modules LED sur le support d'accueil peut être aléatoire et peut comporter une projection par spray des modules LED, ou une mise en suspension des modules LED dans une solution puis une sédimentation des modules LED sur le support d'accueil et un retrait du milieu de la solution dans lequel les modules LED ont été dispersés.

En variante, le report des modules LED peut être mis en œuvre de façon pseudo-aléatoire en utilisant une machine de transfert apte à reporter simultanément plusieurs modules LED sur une partie du support d'accueil.

La réalisation de chacun des premier et deuxième éléments conducteurs d'alimentation électrique peut comporter le dépôt par impression de plusieurs pistes conductrices s'étendant sensiblement parallèlement les unes des autres, les pistes conductrices d'un premier des deux éléments conducteurs d'alimentation électrique s'étendant sensiblement perpendiculairement aux pistes conductrices d'un deuxième des deux éléments conducteurs d'alimentation électrique.

Le procédé peut comporter en outre, entre le report des modules LED et la réalisation du deuxième élément conducteur d'alimentation électrique, la mise en œuvre des étapes suivantes :
- dépôt d'une résine photosensible recouvrant les modules LED et les parties du support d'accueil se trouvant du côté des modules LED et non recouvertes par les modules LED ;
- insolation de la résine sensible à travers le support d'accueil qui est transparent vis-à-vis de la longueur d'onde utilisée pour cette insolation ;
- développement de la résine insolée tel que des parties restantes insolées de la résine photosensible soient conservées entre les modules LED et forment des éléments de passivation entre les modules LED.

Les modules LED peuvent être réalisés tels qu'ils comportent chacun au moins un micro-aimant et/ou tels que des faces latérales des modules LED soient gravées telles que, lors de la dispersion des modules LED sur le support d'accueil, une disposition des modules LED telle que la face émissive de la LED soit disposée d'un côté du support d'accueil qui est optiquement transparent soit favorisée.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 représente schématiquement une partie d'un dispositif d'affichage, selon un exemple comparatif, ne faisant pas partie de l'invention telle que revendiquée ;
- la figure 2 représente schématiquement des modules LED d'un dispositif d'affichage selon un exemple comparatif, ne faisant pas partie de l'invention telle que revendiquée ;
- les figures 3A à 7B représentent les étapes d'un procédé de réalisation d'un dispositif d'affichage selon un exemple comparatif, ne faisant pas partie de l'invention telle que revendiquée ;
- la figure 8 représente un exemple de µLED d'un dispositif d'affichage selon un exemple comparatif, ne faisant pas partie de l'invention telle que revendiquée ;
- la figure 9 représente schématiquement un module LED comportant deux LEDs montées tête-bêche ;
- la figure 10 représente un procédé de réalisation de modules LED ;
- la figure 11 représente schématiquement un circuit électronique de commande d'un module LED ;
- la figure 12 représente les étapes d'un procédé de réalisation de modules LED à pré-orientation ;
- les figures 13A et 13B représentent schématiquement un module LED à pré-orientation ;
- la figure 14 représente une variante de report de modules LED ;
- les figures 15 et 16 représentent des courbes de simulation de dispersion aléatoire des modules LED ;
- les figures 17 et 19 représentent des schémas d'un exemple de réalisation d'un circuit électronique de commande d'un module LED ;
- la figure 18 des signaux obtenus lors d'un affichage par un module LED ;
- la figure 20 représente schématiquement un dispositif d'affichage comprenant les zones différenciées par couleur à afficher ;
- la figure 21 représente schématiquement une partie d'un dispositif d'affichage selon l'invention, dans lequel les modules LED communiquent par signaux RF ;
- les figures 22 et 23 représentent schématiquement un module LED selon l'invention communiquant par signaux RF ;
- la figure 24 représente schématiquement les éléments réalisant une transmission de signaux par ondes RF au sein du dispositif d'affichage ;
- la figure 25 représente schématiquement une partie du dispositif d'affichage selon un mode de réalisation selon l'invention ;
- les figures 26A et 26B représentent des schémas d'antennes RF utilisées dans un dispositif d'affichage ;
- la figure 27 représente schématiquement une partie du dispositif d'affichage selon un un exemple comparatif, ne faisant pas partie de l'invention telle que revendiquée ;
- la figure 28 représente un diagramme d'un procédé d'affichage d'une image selon un mode de réalisation particulier.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

Il est proposé ici un dispositif d'affichage réalisé par report de LEDs de façon non déterministe, aléatoire ou pseudo-aléatoire, sur un support de report (par exemple une plaque contenant des composants TFT ou une plaque support non fonctionnalisée). Le support de report comprend au moins une piste conductrice correspondant par exemple aux futures lignes ou colonnes d'une future matrice.

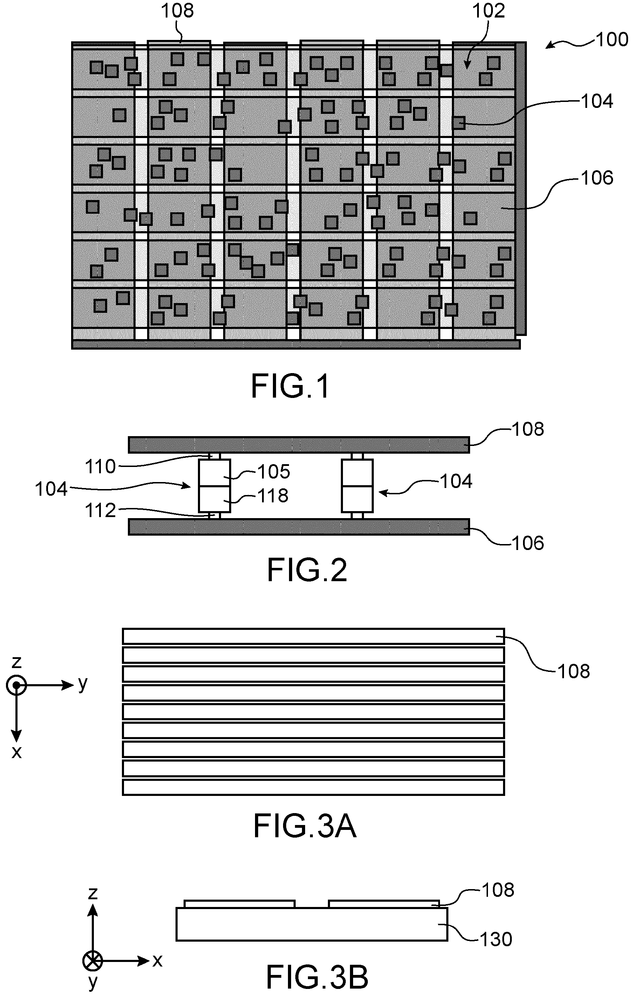

On se réfère tout d'abord à la figure 1 qui représente schématiquement un dispositif d'affichage 100 selon un un premier exemple comparatif, ne faisant pas partie de l'invention telle que revendiquée.

Le dispositif 100 forme une matrice de n x m zones pixel d'affichage 102. Une zone pixel d'affichage 102 correspond à une région d'un plan d'affichage du dispositif 100 destinée à l'affichage d'un point image commandé individuellement par rapport aux autres points image du plan d'affichage. Chaque zone pixel d'affichage 102 comporte un ou plusieurs modules LEDs 104 assurant l'émission lumineuse de cette zone pixel d'affichage 102 (une zone pixel d'affichage défectueuse peut toutefois comporter aucun module LED, comme cela est décrit plus loin). Tous les modules LEDs 104 présents dans une même zone de pixel d'affichage fonctionnent de manière conjointe pour afficher le point image correspondant. Dans le premier exemple comparatif décrit ici, chaque zone pixel d'affichage 102 correspond à un pixel du plan d'affichage. Sur la figure 1, une partie seulement de cette matrice de pixels est représentée et correspond à un ensemble de 36 pixels répartis sur 6 lignes et 6 colonnes de pixels.

Les modules LED 104 comprennent chacun une LED 105 et un circuit électronique de commande 118. Les LEDs 105 sont réalisées par exemple à partir d'au moins un semi-conducteur inorganique, avantageusement du GaN et/ou de l'InGaN et/ou de l'AlGaN. Comme cela est visible sur la figure 2, chaque module LED 104 comporte d'un côté la LED 105, et de l'autre le circuit électronique de commande 118. Les dimensions de chaque module LED 104, dans un plan parallèle à l'interface entre le circuit électronique de commande 118 et la LED 105, sont par exemple comprises, dans le cas de modules microLED, entre environ 1 µm et 100 µm, ou entre environ 5 µm et 100 µm, en fonction notamment de l'encombrement du circuit électronique de commande 118 qui va dépendre de sa complexité, c'est-à-dire du nombre et du type de fonctions mises en œuvre par ce circuit 118. L'épaisseur de chaque module LED 104 est par exemple comprise entre environ 2 µm et 10 µm.

Les LEDs 105 peuvent émettre soit une lumière de couleur variable, ou bien émettre une lumière monochrome. Lorsque des LEDs 105 monochromes sont utilisées, différentes LEDS 105 émettant des lumières de couleurs rouge, vert et bleu (et éventuellement blanc) sont de préférence reportées afin d'avoir dans chaque pixel au moins une LED 105 de chacune de ces couleurs (sauf dans les zones pixel d'affichage 102 défectueuses).

Les modules LED 104 sont ici répartis de manière aléatoire, au sein des zones pixel d'affichage 102 du dispositif 100. La densité avec laquelle les modules LED 104 sont répartis est telle que statistiquement, chaque zone pixel d'affichage 102 comporte au moins un module LED 104 sauf pour un nombre limité de zone 102. Chaque zone 102 peut toutefois comporter plusieurs modules LED 104.

Chaque module LED 104 comporte deux plots d'alimentation électrique 110, 112 reliés à des éléments conducteurs d'alimentation électrique 106, 108 du dispositif 100. Comme cela est visible sur la figure 2, la LED 105 de chaque module LED 104 et le circuit électronique de commande 118 de chaque module LED 104 sont tous deux reliés, via le plot 110, à l'un des éléments conducteurs 108 et reliés, via le plot 112, à l'un des éléments conducteurs 106. Les éléments conducteurs 108 sont optiquement transparents ou semi-transparents afin de permettre l'émission lumineuse des LEDs 105.

Sur la figure 1, les éléments conducteurs 106 sont réalisés sous la forme de lignes électriquement conductrices s'étendant selon une première direction (horizontalement sur la figure 1), et les éléments conducteurs 108 forment des colonnes électriquement conductrices s'étendant selon une deuxième direction sensiblement perpendiculaire à la première direction (verticalement sur la figure 1).

Un potentiel d'alimentation électrique, appelé Vₐₗᵢₘ, est par exemple destiné à être appliqué sur les éléments conducteurs 106 et un potentiel électrique de référence (par exemple la masse), appelé Vₘₐₛₛₑ, est destiné à être appliqué sur les éléments conducteurs 108. Au sein de chaque zone 102, chacun des modules LED 104 est donc relié à ce potentiel d'alimentation et au potentiel de référence.

On propose donc ici un écran réalisé par report de LEDs reportées par exemple de façon non-déterministe sur un support de report. Le support de report peut correspondre à une plaque sur laquelle sont formées l'un des éléments conducteurs 106, 108 sous forme de lignes ou de colonnes comme c'est le cas dans le premier exemple comparatif décrit ci-dessus. Le support de report peut également correspondre à une plaque TFT incluant des éléments électroniques de commande.

Ce report particulier des modules LED 104 est possible grâce aux dimensions importantes des surfaces d'accueil ou surface de contact des modules LED 104, c'est-à-dire aux dimensions des éléments électriquement conducteurs 108, par rapport à celles des modules LED et plus particulièrement aux dimensions des plots conducteurs présents sur chaque module LED et destinés à permettre l'alimentation du module LED. En effet, étant donné que les dimensions de ces éléments électriquement conducteurs sont bien plus importantes que celles des modules LED 104 et donc également des plots d'alimentation électrique 110, 112 vis-à-vis des surfaces de contact des éléments électriquement conducteurs 108, il n'est pas nécessaire de réaliser un positionnement précis des modules LED 104 sur ces surfaces d'accueil. Ces dimensions sont telles que dans un plan parallèle aux surfaces de contact, un rapport entre les dimensions d'une des surfaces de contact sur le support et celles d'une des deux faces opposées d'un des modules LED est supérieur ou égal à 2, ou supérieur ou égal à 5, voire supérieure ou égale à 10. La surface de contact sur le support correspond à la surface disponible pour réaliser le contact électrique avec un des modules LED 104, cette surface pouvant éventuellement être partiellement ajourée ou constituée de différentes surface reliées électriquement et à un même potentiel.

On décrit en lien avec les figures 3A à 7B des étapes d'un procédé de réalisation du dispositif 100.

Un premier niveau d'électrode est tout d'abord réalisé (figures 3A et 3B). Dans l'exemple décrit ici, il s'agit des éléments conducteurs 108 destinés à se trouver du côté des faces émissives des LEDs 105. Un support 130 transparent est utilisé, par exemple en verre. Des bandes d'ITO sont ensuite gravées au pas correspondant au pas des zones pixel d'affichage 102 souhaité, de préférence par gravure laser des zones inter bandes à partir d'un plan continu, ou couche continue, d'ITO. Ces bandes d'ITO forment les éléments conducteurs 108.

Les modules LED 104 sont mis en suspension idéalement dans un mélange eau-IPA et maintenus en suspension par agitation ultrasonique. L'équipement peut-être avantageusement du type de ceux utilisés pour les écrans à cristaux liquide, pour la dispersion aléatoire des espaceurs.

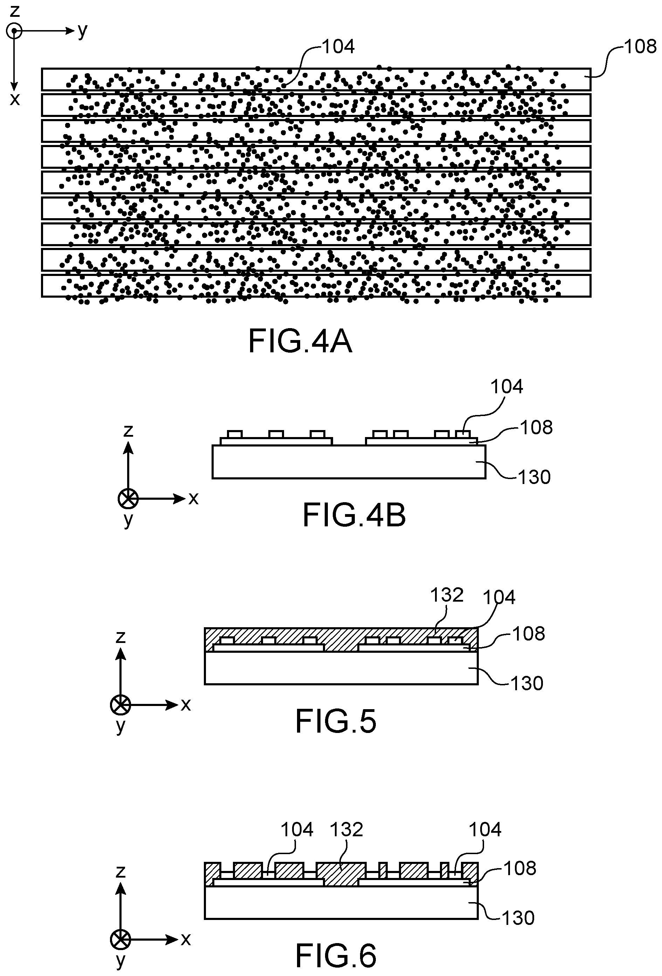

Les modules LED 104 sont ensuite dispersés aléatoirement par exemple par spray de façon à minimiser le nombre de zones 102 défectueuse, sur les éléments conducteurs 108 (figures 4A et 4B). Pour un écran de 1.10⁶ pixels ou zones 102, on dispense un volume de solutions contenant de l'ordre de 1.10⁷ modules LED 104, ce qui doit assurer un taux de défauts de l'ordre de 10. Un collage direct métal - métal peut être réalisé pour assurer la connexion des modules LED 104 avec les éléments conducteurs 108.

Une résine 132 isolante de type négative est répartie sur l'ensemble de la structure réalisée, de préférence par spray et d'une épaisseur de préférence supérieure à l'épaisseur des modules LED 104 (figure 5). Cette résine est avantageusement de couleur noire afin d'obtenir un bon contraste avec les LEDs 105 lors d'une émission de lumière avec une émission de lumière ambiante non nulle, ainsi que d'avoir un plan d'affichage de couleur noire lorsque les LEDs 105 n'émettent pas de lumière.

Une insolation au travers du support transparent 130 et des éléments conducteurs 108 permet d'insoler la résine 132 entre les modules LED 104 et non la résine présente sur les modules LED 104. Un développement de la résine 132 permet ensuite de retirer la résine non insolée présente sur les modules LED 104 (figure 6). Les portions restantes de la résine assurent une passivation entre les modules LED 104.

Enfin, les autres éléments conducteurs 106 sont réalisés par exemple par impression des électrodes métalliques (perpendiculaires aux électrodes précédentes. La résine 132 déposée à l'étape précédente assure alors un rôle de lissage favorisant le dépôt des éléments conducteurs 106 par impression.

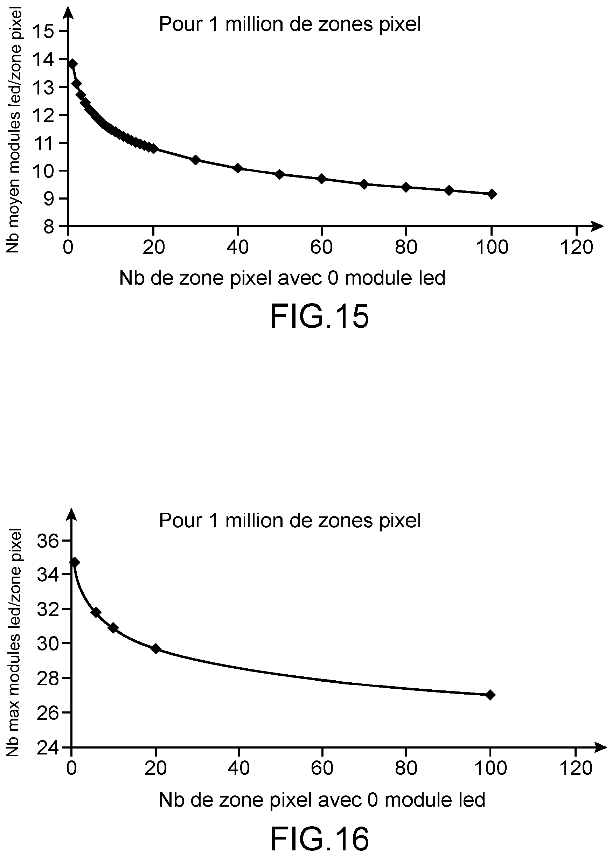

Dans ce processus de dispersion aléatoire des modules LED 104, la répartition suit une loi de Poisson. En prenant l'hypothèse d'un nombre de zones pixel d'affichage 102 de 1.10⁶ et en utilisant la loi de Poisson, il est possible d'évaluer le nombre de modules LED 104 qu'il faut dispenser en fonction du nombre de défauts que l'on accepte pour le dispositif 100. On entend par défaut une zone pixel d'affichage 102 où il n'y a pas de module LED 104 ou pas de module LED 104 fonctionnel. Dans le graphique représenté sur la figure 15, en considérant un million de zones pixel d'affichage 102, il faut dispenser de l'ordre de 14 millions de modules LED 104 sur le support d'accueil pour n'avoir qu'une seule zone pixel d'affichage 102 défectueuse (le nombre moyen de modules LED 104 par zone pixel étant alors de 14). En dispersant 10 millions de modules LEDs, on obtient environ 45 zones pixel d'affichage 102 défectueuses. Il est également possible d'estimer le nombre maximal de modules LED 104 que l'on peut trouver dans une zone pixel d'affichage 102 en fonction du nombre de défauts acceptés. Ainsi, sur la figure 16, en acceptant une seule zone pixel d'affichage 102 défectueuse, il est possible de trouver une zone pixel d'affichage 102 comprenant 35 modules LED 104.

Dans le procédé décrit ci-dessous, les modules LED 104 sont répartis grâce à une dispersion par spray sur le support 130 et les éléments conducteurs 108. En variante, il est possible de placer les modules LED 104 dans un liquide pour obtenir une suspension colloïdale des modules LED 104. Cette suspension est répartie sur le support 130 et les éléments conducteurs 108 puis, par sédimentation et ensuite aspiration du medium dans lequel se trouvent les modules LED 104, les modules LED 104 se retrouvent disposés sur les éléments conducteurs 108.

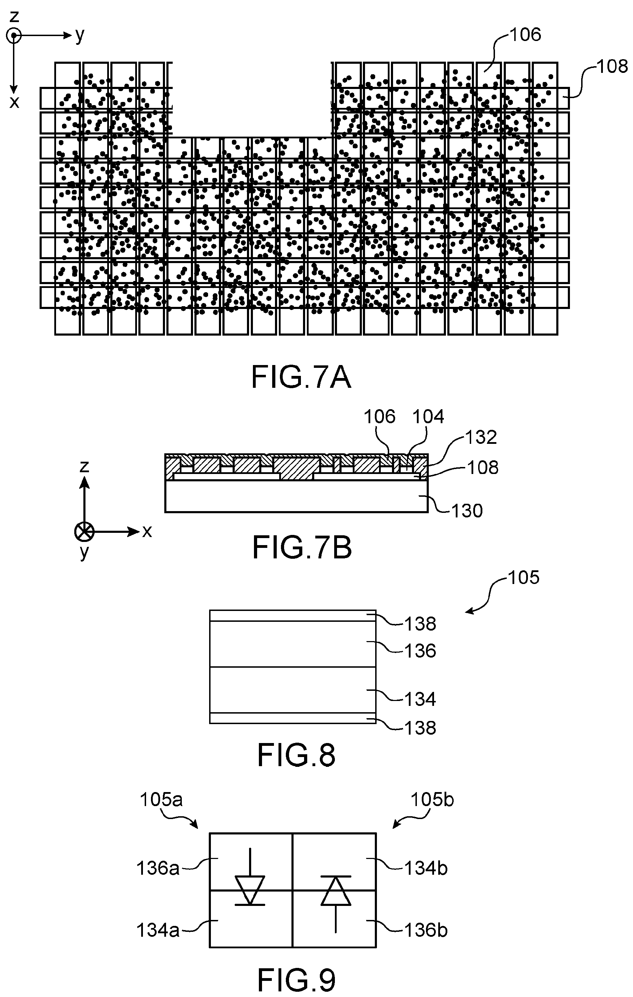

Les LEDs 105 des modules LED 104 sont par exemple comme celle représenté sur la figure 8. Cette LED 105 comporte une couche 134 de semi-conducteur dopé n disposée contre une couche 136 de semi-conducteur dopé p, cet empilement formant une jonction p-n étant disposé entre deux couches conductrices 138 comprenant par exemple de l'ITO (transparent pour permettre l'émission lumineuse de la LED 105). Le semi-conducteur des couches 134, 136 est par exemple du GaN. Les couches 138 facilitent le contact avec les éléments conducteurs 106, 108.

En répartissant de manière aléatoire les modules LEDs 104 sur le support, certains de ces modules LED 104 ne sont pas disposés dans le bon sens, c'est-à-dire comportent leur face lumineuse qui n'est pas du bon côté du plan d'affichage. Toutefois, étant donné le grande nombre de modules LED 104 dispersés, on obtient statistiquement un nombre suffisant de modules LED 104 orientés correctement. Les modules LED 104 inversés ne posent pas de problème électrique car sous tension, ces modules LED 104 forment des diodes polarisées en inverse ne perturbant pas le fonctionnement des autres modules LED 104 orientés correctement. Lorsque chaque module LED 104 comporte un circuit de commande 118 de type CMOS, l'architecture CMOS de ce circuit 118 est telle qu'une polarisation en inverse ne créé pas de courtcircuit.

Dans l'exemple comparatif décrit ci-dessus, les modules LED 104 dispersés comportent une LED 105 et un circuit de commande 118. En variante, il est possible que les modules LED 105 ne comportent pas de circuit de commande 118, mais uniquement une ou plusieurs LEDs 105.

De manière avantageuse, il est possible que chaque module LED 104 comporte deux LEDs 105 disposées tête-bêche l'une à côté de l'autre. Une telle configuration est représentée sur la figure 9 sur laquelle, au niveau d'une première face, une première LED 105a comporte la couche 134a dopée n et une deuxième LED 105b comporte la couche 136b dopée p, et au niveau d'une deuxième face opposée à la première, la première LED 105a comporte la couche 136a dopée p et la deuxième LED 105b comporte la couche 134b dopée n. Ainsi, l'une des LEDs 105 sera fonctionnelle quelle que soit la face (première ou deuxième) qui se retrouve en contact avec l'un des éléments conducteurs 108.

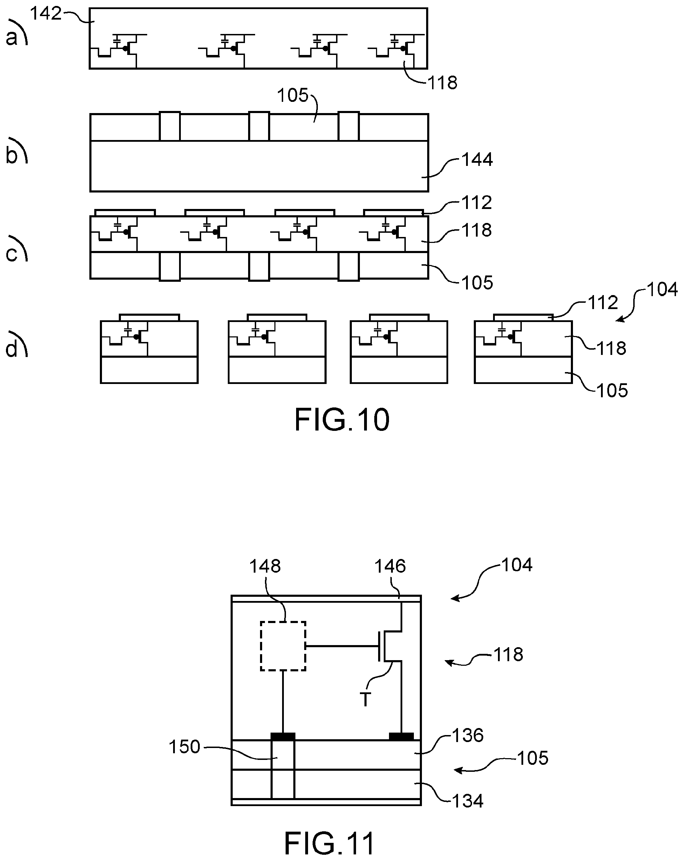

Un exemple de procédé de réalisation de modules LED 104 est décrit en lien avec la figure 10.

A l'étape a) de cette figure, une matrice des circuits électroniques de commande 118 est réalisée en technologie CMOS dans un substrat 142 de semi-conducteur, par exemple de silicium.

Parallèlement à la réalisation de la matrice de circuits électroniques de commande 118, une matrice de LEDs 105 est réalisée à partir d'un autre substrat 144 de semi-conducteur, par exemple par épitaxie (étape b)).

La matrice de circuits électroniques de commande 118 est ensuite reportée sur la matrice de LEDs 105. Des reprises de contact entre les circuits électroniques de commande 118 et les LEDs 105 sont réalisées lors de cet assemblage. Le semi-conducteur du substrat 142 est ensuite aminci puis les plots 112 sont ensuite réalisés du côté des circuits de commande 118. Le substrat de croissance 144 est ensuite retiré (étape c)).

Une gravure et une singularisation des modules LED 104 sont ensuite mises en œuvre (étape d)). Ces modules LED 104 peuvent ensuite être mis en solution.

Un exemple de réalisation du circuit électronique de commande 118 est représenté sur la figure 11. Ce circuit comporte un transistor MOS T relié entre un contact 146, par exemple d'ITO, destiné à être relié à l'élément conducteur 106, et la LED 105. La grille du transistor T est reliée au contact 146. Le circuit 118 comporte également une partie CMOS 148 non détaillée ici et destinée au traitement des signaux de données destinés à être reçus par le module LED 104 et au pilotage du transistor T alimentant électriquement la LED 105. Cette partie 148 peut correspondre à un simple transistor CMOS lorsqu'aucune fonction autre que l'alimentation électrique de la LED 105 n'est remplie par le circuit 118. Cette partie 148 est reliée à un deuxième contact 150, par exemple d'ITO, destiné à être relié à l'élément conducteur 108 et se trouvant du côté de la face émissive de la LED 105. Le contact 150 est relié à la partie 148 par l'intermédiaire d'un via conducteur 152 qui est isolé électriquement vis-à-vis des couches de semi-conducteur 134 et 136 de la LED 105.

Lors de la dispersion des modules LED 104, il est avantageux de favoriser le positionnement des modules LED 104 dans le bon sens, c'est-à-dire d'avoir les modules LED 104 orientés tels que les faces émissives du plus grand nombre de LED 105 soient tournées vers la face d'affichage du dispositif 100. Il faudra dès lors prévoir d'utiliser une technique de pré-orientation des modules LED avant/pendant leur report sur le support.

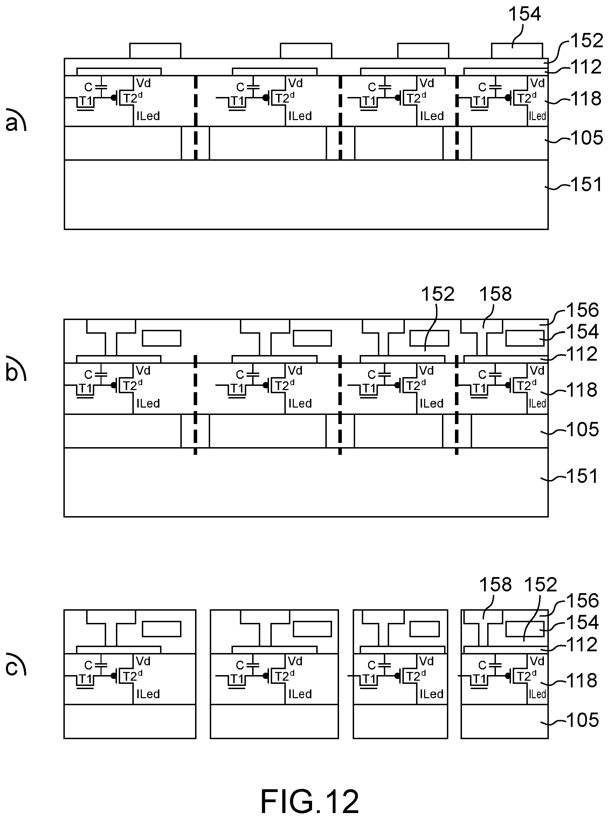

Une première solution pour favoriser cette bonne orientation peut être d'incorporer des micro-aimants au sein des modules LED 104. Ces micro-aimants peuvent servir à assembler par la suite les modules LED 104 du bon côté lors d'un placement aléatoire des modules LED 104. Par exemple, en reprenant le procédé décrit précédemment en lien avec la figure 10, à l'issue de l'étape c), un diélectrique 152 tel que du SiO₂ est déposé sur la face comportant les plots 112. Une poignée temporaire 151 est solidarisée aux LEDs 105, le collage de cette poignée temporaire 151 pouvant être réalisé avant l'amincissement du substrat 142. Une planarisation de ce diélectrique 152 est ensuite mise en œuvre, puis des micro-aimants 154 sont disposés sur ce diélectrique planarisé, répartis tels qu'au moins un micro-aimant 154 soit associé à chaque module LED 104 (voir figure 12, étape a). Les micro-aimants 154 sont recouverts d'une couche diélectrique 156, par exemple de même nature que le diélectrique 152, puis une reprise de contact des plots 112 est réalisée à travers cette couche diélectrique 156 et le diélectrique 152 par l'intermédiaire de vias conducteurs 158 formés par exemple par un procédé damascène (figure 12, étape b)). Une singularisation des modules LED 104 par gravure de l'empilement réalisé est ensuite mise en œuvre, la poignée temporaire 151 étant retirée (figure 12, étape c)). Ainsi, le procédé damascène permet de préparer une surface compatible avec un collage direct. En intégrant ainsi des micro-aimants 154 au sein des modules LED 104, le positionnement de ces modules LED 104 est influencé car le micro-aimant 154 est attiré du côté des éléments conducteurs 106, favorisant ainsi le bon positionnement des faces émissives des LEDs 105.

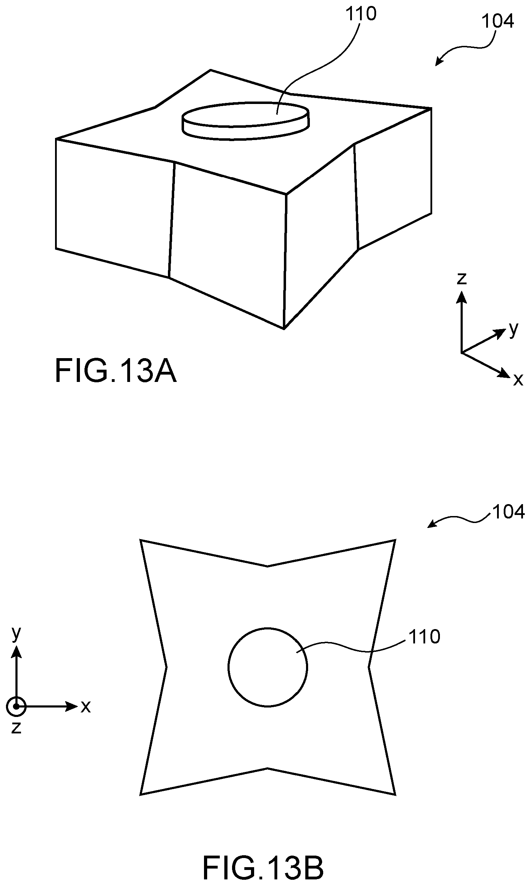

D'autres configurations des modules LED 104 peuvent favoriser la bonne orientation de ces modules. Par exemple, pour éviter un positionnement d'un module LED 104 tel que l'une des faces latérales se trouve du côté des éléments conducteurs 108, il est possible de graver les modules LED 104 selon une forme telle que représentée sur les figures 13A et 13B, c'est-à-dire comportant des parties gravées au niveau des faces latérales. La face supérieure du module LED 104 comporte le contact 110 autour duquel une gravure de l'isolant a été faite en partie pour mettre ce contact en relief. De cette façon, après dispersion par la méthode de spray décrite précédemment, seule la face du bas du module LED 104 aura une adhésion (par les forces de Van der Walls) suffisante pour résister à un rinçage (éventuellement assisté par un peu de HP). Les modules LED 104 qui n'ont pas adhérer aux éléments conducteurs 108 sont recyclés. Dans cette configuration, il est judicieux de disperser un nombre de modules LED 104 au moins 6 fois supérieur au nombre de modules LED 104 que ce qui est prévu par la loi de Poisson. Une unique dispersion des modules LED 104 est très intéressante car une part de l'indétermination est levée car les zones surpeuplées avec formations de clusters de modules LED 104 seront nettoyées de ces clusters qui ne peuvent se fixer de par la forme des modules LED 104.

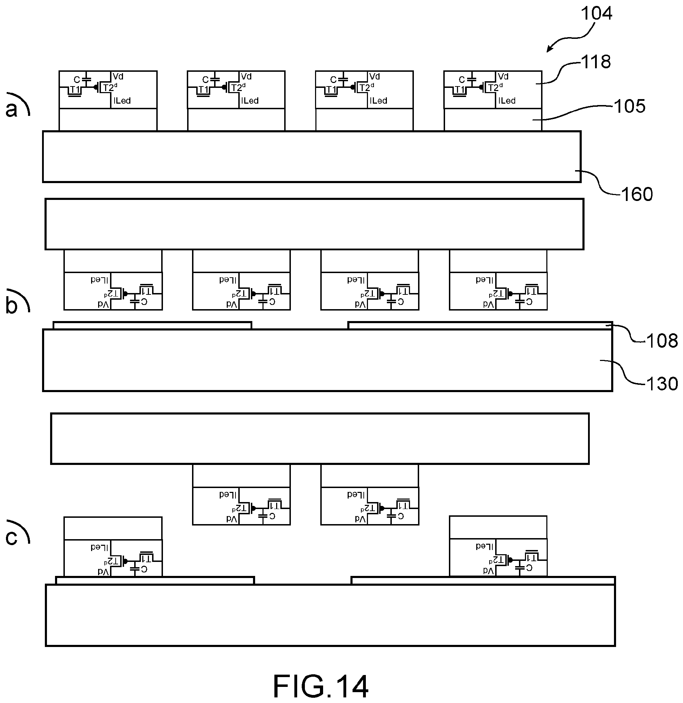

Une autre manière de disperser ou disposer les modules LED 104 sur les surfaces d'accueil formées par les éléments conducteurs est représentée sur la figure 14.

Les modules LED 104 sont reportés sur une poignée temporaire 160, faces émissives disposées contre cette poignée 160 (figure 14, étape a)). Cet ensemble est ensuite retourné (figure 14, étape b)) et une partie des modules LED 104 sont détachés sur les éléments conducteurs 108 (figure 14 étape c)). Les contraintes de positionnement sont relâchées en raison des dimensions des éléments conducteurs 108 qui sont plus importantes que celles des modules LED 104. La poignée temporaire pourrait également se présenter sous la forme d'un substrat flexible qui pourrait être étiré avant d'être retourné. Dans ce cas, le positionnement des modules LED sur les surfaces d'accueil des éléments conducteurs 108 sera différent d'un dispositif d'affichage à un autre, et le positionnement des modules LED sur une surface d'accueil considérée est ainsi pseudo-aléatoire.

Dans les exemples précédemment décrits, la dispersion des modules LED 104 est réalisée de manière non-déterministe pour leur positionnement et éventuellement de manière non-aléatoire pour leur orientation lorsqu'une technique de pré-orientation des modules LED est mise en œuvre. Toutefois, le fait d'avoir des surfaces d'accueil de dimensions bien supérieure à celles des modules LED reportés permet également de mettre en œuvre des solutions de transfert déterministe, par exemple via une machine reportant les modules LED 104 sur la surface d'accueil, en relâchant les contraintes d'alignement imposées en raison de ces dimensions. Ainsi, il est possible de travailler avec des surfaces de report plus importantes que lorsque les modules LED doivent être reportés sur des contacts électriques de taille semblable à celle des plots des modules LED. Par exemple, il est possible de travailler avec une machine de report dont l'élément de report (appelé « stamp ») de dimensions 5 cm x 5 cm pour reporter les modules LED 104 au pas de 250 µm, soit 50 000 modules LED 104 simultanément. Le positionnement de l'élément de report par rapport à la surface d'accueil n'a pas besoin d'être précise (+/-10 µm peut suffire), ce qui permet de gagner en vitesse de transfert et donc en coût de procédé.

Le rendement de transfert n'est pas de 100 %. Pour être sûr d'avoir au moins un module LED 104 (voire 3 modules si on veut trois couleurs par zone pixel avec des modules LED 104 monochromes), il faudrait mettre de la redondance par zone pixel d'affichage. En supposant un rendement de transfert de 99 %, si l'on double les transferts alors il est possible d'atteindre 99,99 % des pixels ayant au moins un module LED 104. Ce chiffre de 99,99% correspond au cas où le rendement de transfert est indépendant d'un transfert à l'autre. Si l'élément de report a un défaut localement, il y a une dépendance d'un transfert à l'autre et dans ce cas le doublement des étapes transfert peut seulement recopier le défaut (le même rendement global est obtenu après un second passage de l'élément de report). Pour pallier cet éventuel défaut lié localement au repère de l'élément de report, l'étape de redondance de transfert peut se faire avec un décalage de Nx, Ny zones pixel d'affichage (Nx pour le nombre de zones pixel en ligne, et Ny pour le nombre de zones pixel en colonne) de sorte que les défauts fixes de l'élément de report se répartissent spatialement sur le support d'accueil.

S'il y a besoin d'augmenter encore la redondance pour atteindre un meilleur rendement global, chaque passage de l'élément de report sur une même zone d'accueil peut être décalé. En visant un rendement de 10 défauts /10⁶ zones pixel d'affichage, alors avec un rendement de transfert de 99 %, 3 passages de l'élément de report sur la surface d'accueil suffisent. Si le rendement de transfert est de 96 %, 4 passages peuvent suffire. Typiquement, les différents passages peuvent être décalés de plusieurs pixels.

Dans le dispositif 100 décrit précédemment, les modules LED 104 comportent leurs plots d'alimentation électriques 110, 112 reliés aux éléments conducteurs d'alimentation électrique 106, 108 sur lesquels la tension d'alimentation est appliquée pour alimenter électriquement les modules LED 104. Les seuls plots de contact des modules LED 104 sont les plots d'alimentation 110, 112, et les signaux de données permettant de piloter et commander les modules LED 104 doivent être amenés jusqu'au modules LED autrement que par des connexions filaires dédiées. Ainsi, dans cet exemple, les signaux de commande sont transmis aux modules LED 104 par l'intermédiaire de ces plots d'alimentation 110, 112 et de ces éléments conducteurs 106, 108 sous la forme d'un signal de modulation que les modules LED 104 doivent interpréter.

D'autres façons d'amener les signaux de commande des LED peuvent être envisagés, par exemple par voie RF (voir infra).

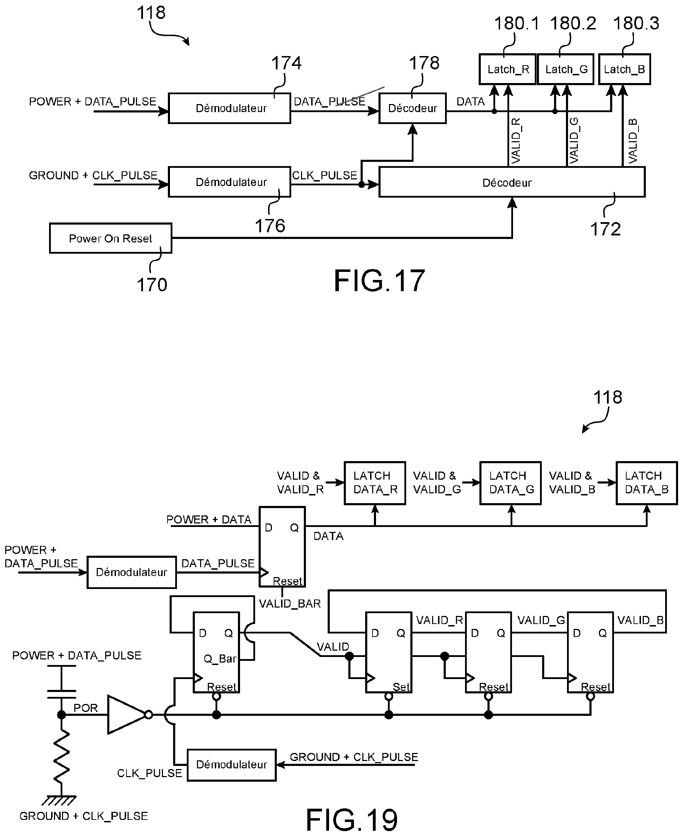

La figure 17 représente un schéma bloc des fonctions implémentées dans le circuit électronique de commande 118 de chaque module LED 104 afin de réaliser la commande par modulation PWM (modulation par largeur d'impulsion) ou BCM (modulation codée binaire) d'une LED 105 du module à partir des données et des signaux de synchronisation transmis par modulation d'amplitude de la tension d'alimentation présente sur un conducteur d'alimentation électrique 106, 108.

Ce schéma bloc décrit une architecture adaptée à un module LED 104 à 3 canaux (RGB) permettant de réaliser la fonction d'adressage et d'écriture d'une donnée binaire. Le module LED comprend ainsi 3 LED avec leurs interrupteurs de commande respectifs, similaires à l'exemple représenté en figure 11.

A la mise sous tension, un bloc PoR (Power on Reset) 170 initialise un premier décodeur 172 appelé décodeur_1 qui pointe à un instant donné sur l'un des trois canaux, par exemple sur le canal R (rouge), et initialise, par exemple à « 0 » , également les données RGB, dans trois éléments de mémorisation type bascules (latch en anglais) Latch_R, Latch_G et Latch-B.

Des démodulateurs 174, 176 reçoivent chacun les signaux d'alimentation depuis les éléments conducteurs 106, 108 qui incluent les signaux de données et de synchronisation par modulation d'amplitude respectivement des tensions d'alimentation « POWER » et de masse « GROUND » . Le signal de données est appelé « POWER + DATA_PULSE » et le signal de synchronisation appelé « GROUND + CLK_PULSE ». Ces démodulateurs 174, 176 permettent d'extraire les variations des tensions d'alimentation et de masse afin d'en reconstruire des signaux binaires (appelés DATA_PULSE et CLK_PULSE).

Le signal DATA_PULSE est envoyé à l'entrée d'un deuxième décodeur 178, délivrant en sortie le signal de donnée DATA permettant in fine la commande de la LED 105. Le signal DATA est mémorisé dans un des trois éléments mémoires 180.1, 180.2, 180.3 utilisés pour les 3 canaux RVB en fonction des signaux issus du décodeur 172, VALID_R, VALID_G, VALID_B . L'ensemble est synchronisé par le décodeur 172 qui change le canal sélectionné à chaque impulsion du signal d'horloge CLK_PULSE via l'envoi des signaux VALID_R, VALID_G, VALID_B aux éléments mémoires 180.1, 180.2 et 180.3.

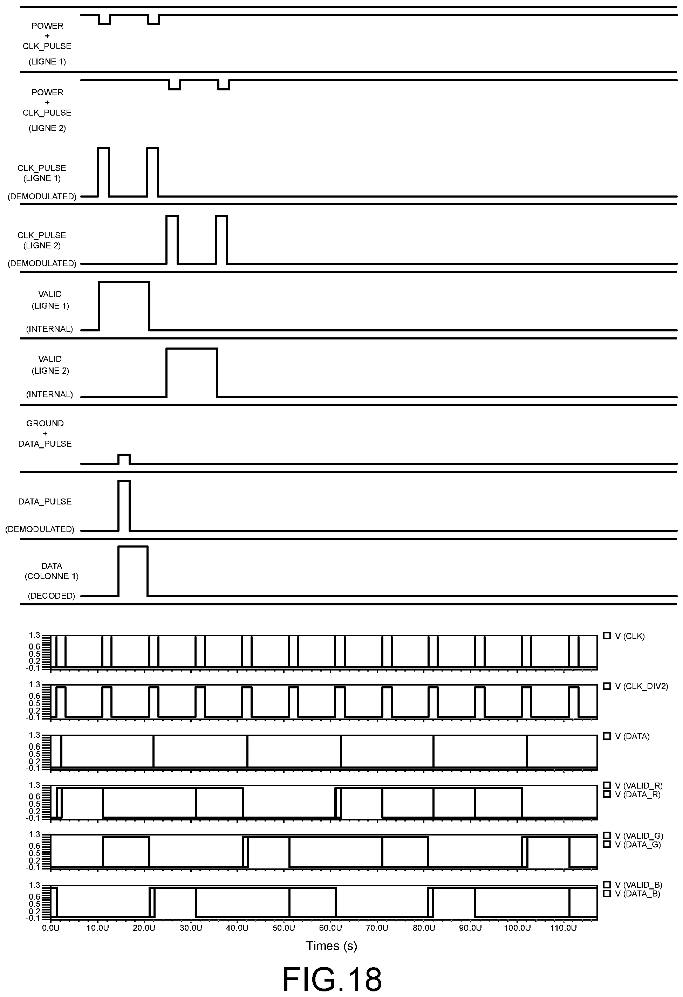

La figure 18 représente des exemples de chronogrammes de signaux obtenus dans ce circuit. L'envoi de 2 impulsions sur CLK_PULSE permet d'une part d'incrémenter le choix du canal RVB, puis permet de définir une fenêtre de temps durant laquelle on attend de voir si on reçoit ou pas une impulsion de DATA_PULSE. Si oui, alors on écrit par exemple un 1 dans l'élément de mémorisation correspondant au canal (R, V ou B) sélectionné, sinon on écrit un 0.

Dans cet exemple, la valeur mémorisée dans chaque point mémoire de type latch (mémorisant une unique valeur binaire) est utilisée pour contrôler directement l'interrupteur de commande d'une LED 105 en mode « tout ou rien » (la LED étant conductrice ou non conductrice car respectivement reliée ou non relié à la tension d'alimentation).

Afin de pouvoir contrôler l'intensité lumineuse d'une LED 105, il est nécessaire de piloter le temps de conduction et de non conduction. Ainsi, la valeur présente dans chaque point mémoire doit être modifiée au cours de chaque trame d'image.

L'adressage en PWM (« Pulse Width Modulation ») ou BCM permet en écrivant seulement des 1 et des 0 de moduler la luminance moyenne émise par une LED 105 en modulant son temps d'allumage : 1 = allumé, 0 = éteint. Si la LED 105 est allumée pendant tout le temps image, cela correspond au code maximal, par exemple sur 3 bits : 111. Si par contre la LED 105 est éteinte pendant tout le temps image, alors cela correspond au code minimum : 000.

Dans cet exemple avec 3 bits d'adressage, la durée d'allumage ou d'extinction associée au bit le plus significatif (le troisième) correspond à quatre fois celle associée au bit le moins significatif (le premier), et celle associée au deuxième bit correspond à deux fois celle associée au bit le moins significatif. La durée d'allumage ou d'extinction peut être codée en choisissant une valeur comprise entre 0 et 7.

Ici, le contrôle de la luminosité émise par la LED, pendant l'affichage de chaque image, est réalisé en commandant le rapport entre la durée pendant laquelle la LED est allumée et la durée totale d'affichage de l'image sur l'écran. Une telle commande des LED peut être obtenue en utilisant des mots ou informations binaires, (c'est-à-dire un code binaire sur un certain nombre de bits permettant de contrôler l'affichage de l'image) de type BCM dans lesquels la luminosité de chaque pixel est codée sous la forme d'un signal binaire. Chaque bit d'un tel mot binaire pilote l'allumage ou l'extinction de la LED pendant une durée proportionnelle au poids du bit. Par exemple, le bit de poids fort (MSB pour « Most Significant Bit ») pilote la LED pendant la moitié de la durée d'affichage de l'image (par exemple 10 ms pour un dispositif d'affichage fonctionnant à une fréquence de 50 images/seconde). Le bit suivant (appelé MSB-1) représente le quart de cette durée, et ainsi de suite jusqu'au bit de poids faible (appelé LSB pour « Less Significant Bit »).

Dans le cas d'un dispositif d'affichage de type matriciel tel que celui décrit en relation avec la figure 1, on pourra ainsi prévoir que chaque ligne de pixels soit adressée 3 fois au cours d'une trame, avec des intervalles de temps décroissant. Ainsi le premier intervalle de temps dure 4 fois plus longtemps que le troisième intervalle, et le deuxième intervalle de temps dure 2 fois plus longtemps que le troisième intervalle de temps. Les valeurs mémorisées dans les points mémoires « latch » au cours des premier, deuxième et troisième intervalles de temps correspondent respectivement aux 1er bit (poids fort), 2ème bit et 3^{ème} bit (poids faible).

Dans le cas où les modules comprennent 3 LED, il est nécessaire lors de chaque adressage d'une ligne, de réaliser 3 transmissions d'information pour les 3 canaux (valeurs mémorisées dans les points mémoires respectifs latch_R latch_G et latch_B). Il est ainsi possible d'envisager d'adresser successivement les 3 canaux du module pixel en envoyant 6 impulsions sur CLK_PULSE et d'appliquer ou pas 3 impulsions de DATA_PULSE selon le code à appliquer.

Un tel protocole offre l'avantage d'avoir une architecture très compacte, ce qui est extrêmement avantageux car cela permet de réaliser les modules LED 104 avec de faibles dimensions.

Dans ce protocole, une erreur de démodulation peut entraîner une erreur de sélection de canal ou une erreur de donnée écrite. Si la donnée est fausse, la conséquence est limitée car ponctuelle, par contre une erreur sur la détection du CLK_PULSE provoque une erreur sur la fenêtre de temps et une erreur sur le canal adressé. Dans ce cas une réinitialisation par le Power On Reset est nécessaire.

Afin d'améliorer la robustesse du circuit 118, il est possible de mettre un décodeur binaire en sortie des démodulateurs 174, 176 pour être certain d'adresser le canal R, G, ou B individuellement au lieu d'utiliser un chenillard (séquenceur cyclé). Cela nécessite toutefois plus de surface et nécessite la transmission de plus de données (dont un tag complexe qui permet de savoir quel canal est adressé).

Un exemple de réalisation du circuit 118 mettant en œuvre les fonctions du schéma bloc de la figure 17 est représenté sur la figure 19.

D'autres modes de réalisation d'un circuit électronique de contrôle présent dans le module LED peut être envisagé. On pourra par exemple remplacer chaque élément de mémorisation unitaire (latch) par un élément de mémorisation de plusieurs bits, de type registre afin de mémoriser dans chaque registre la valeur numérique, par exemple sur 3 bits comme précédemment, correspondant à l'intensité lumineuse souhaitée. Dans ce cas, il n'est pas nécessaire de prévoir 3 adressages ligne au cours de la trame, mais un unique adressage ligne qui permette de véhiculer la valeur des 3 bits. Il faudra par suite, rajouter entre chaque registre et l'interrupteur de commande de la LED correspondante un circuit de commande, pour convertir la valeur binaire en signal temporel de commande de la LED. Un avantage d'une telle variante de réalisation est qu'elle permet d'envisager de mettre à jour les valeurs de registre uniquement quand on souhaite modifier l'intensité lumineuse, permettant ainsi une réduction de consommation d'énergie. En outre, associée à un dispositif d'identification de modules LED tel que décrit ci-après, il est possible d'envisager des architectures autres que matricielles.

Après la réalisation du dispositif 100, et avant son utilisation, lorsque les modules LED 102 ont été répartis aléatoirement sur le support d'accueil, le nombre de modules LED 104 par zone pixel d'affichage 102 étant inconnu, une première phase de calibration permet, à travers la lecture de la consommation lorsque les LED 105 d'une zone pixel d'affichage 102 sont ON, de déterminer leur nombre. Connaissant ce nombre, les codes d'affichage sont adaptés de manière inversement proportionnelle pour arriver à la luminosité initialement souhaitée.

D'autres approches de calibration du dispositif d'affichage 100 sont possibles, comme par exemple l'ajustement du courant ou l'ajustement de la tension des zones pixel d'affichage 102 contenant les n modules LED 104. Il est aussi possible d'envisager une détection visuelle pour déterminer la position, la couleur et le nombre de modules LED 104 par zones pixel afficheur 102.

Grace à cette calibration, chaque zone pixel d'affichage 102 fonctionne de la même manière quel que soit le nombre de modules LED 102 dans chacune des zones 102.

En variante, cette calibration peut être réalisée via une identification des modules LED 104. Le processus de communication utilisant une identification des modules LED, peut se faire de différentes manières, par voie filaire ou non filaire (par exemple communication RF).

Préalablement à l'utilisation d'un procédé de communication avec identification des modules, chaque module LED doit recevoir un identifiant. Cette « personnalisation » de chaque module LED peut être réalisée par action sur un composant matériel : en flashant une rom, en brûlant des fusibles pour attribuer un code à chaque module LED 104, ou peut-être réalisée par programmation d'un module LED 104.

Lors d'une procédure de communication avec identification il est également possible d'exploiter des propriétés statistiques pour identifier les modules LED 104 sans qu'ils aient un code unique d'identification. Ceci permet de réduire le nombre de bits d'identification à mémoriser et réduit fortement la complexité des modules LED 104.

Pour cela, « n » modules LED 104 ayant des codes d'identification différents sont réalisés et répartis aléatoirement pour réaliser le dispositif 100. Chaque zone pixel d'affichage 102 possède un ou plusieurs modules LED 104 qui ont une adresse parmi « n ». Lors d'une communication avec les modules LED 104 d'une zone pixel d'affichage 102, un recensement des modules LED 104 est réalisé en balayant les n codes d'adresse afin de connaitre leur nombre et recenser les adresses des modules LED ayant répondu présents. Ainsi, il est possible d'éteindre les modules LED 104 redondants et ne garder qu'un module LED 104 actif par zone pixel d'affichage. Par ce moyen, il n'y a plus d'ajustement à réaliser (tension / courant / code binaire) afin d'avoir un affichage homogène sur tout l'afficheur car il n'y a qu'un seul module LED 104 par zone pixel d'affichage 102.

L'identification peut être réalisée de manière logicielle. Ainsi, il est possible de communiquer avec les zones pixels d'affichage 102 à la manière d'un ordinateur sur le réseau internet en envoyant des requêtes et obtenir une adresse unique sur le réseau. Ceci nécessite un protocole de communication, des éléments d'électronique numérique et de la mémoire.

Un avantage de l'adressage individuel des modules LED 104 c'est qu'il est possible de changer la méthode d'écriture dans le dispositif d'affichage 100. En effet, au lieu de balayer toutes les lignes à tour de rôle en devant rafraichir les données présentes sur le bus colonne afin d'afficher une image, si les pixels ont une adresse propre, alors il est possible de n'adresser que les pixels qui ont changé d'une image sur la suivante, ce qui permet d'obtenir une très basse consommation du dispositif 100.

L'identification par adresse (individuelle ou pas) offre la possibilité de désactiver certains modules LED 104, ceci permet d'exploiter la redondance. En cas de défaillance ou de dispersion trop importante d'un module LED 104, il est possible de le désactiver et d'en sélectionner un autre (si il y en a un) situé dans la même zone pixel d'affichage 102.

Dans les exemples comparatifs décrits précédemment, l'électronique de commande des LEDS 105 est intégrée aux modules LED 104. En variante ou en complément, il est possible que des circuits électroniques de commande soient présents sous le support d'accueil du dispositif 100 auquel les modules LED 104 sont reliés, par exemple réalisés en technologie CMOS. Dans ce cas, ce sont des LEDs nues qui sont reportées.

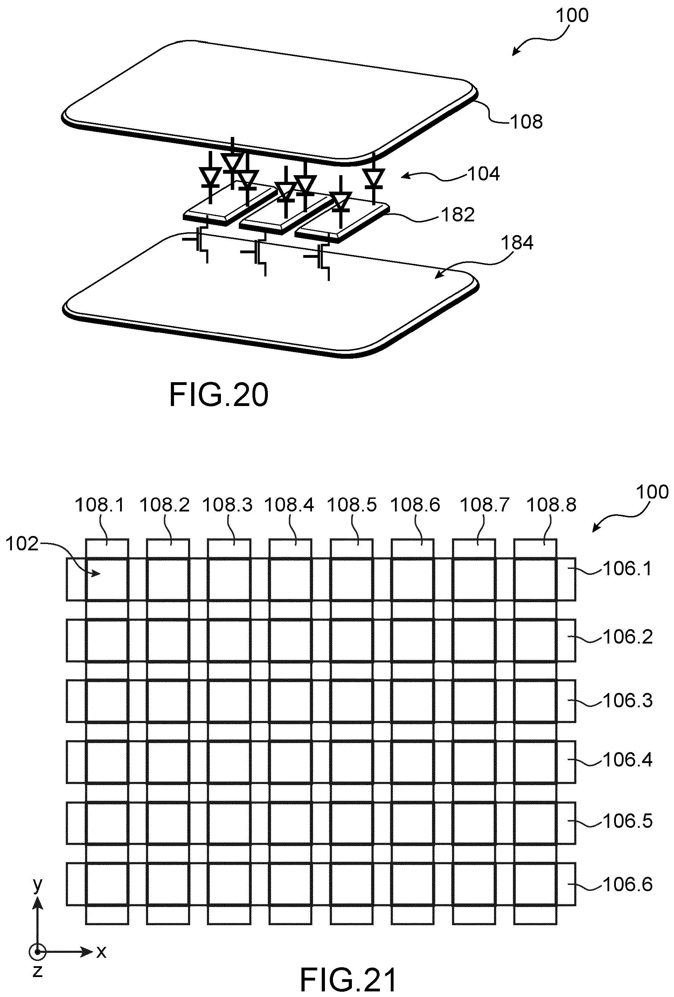

Le support d'accueil peut être structuré suivant des zones différenciées chacune destinée à recevoir des modules LED 104 adaptées à l'émission d'une seule couleur rouge, vert ou bleu. Cela relâche la contrainte de dépôt des modules LED 104 car il est possible de faire appel à un pochoir pour le dépôt des modules LED 104 associés à chacune de ces couleurs et permet de garder une architecture d'afficheur classique en collant en face arrière du support d'accueil une électronique de commande de type MOS grande surface type TFT, Poly-Si. La figure 20 représente schématiquement une telle configuration dans laquelle des zones d'accueil 182 différenciées pour les différentes couleurs sont réalisées pour la disposition des modules LED 104. L'électronique de commande présente en face arrière est référencée 184.

Alternativement à la technologie TFT pour réaliser l'électronique de commande 184, il est possible d'utiliser une plaque de verre et de coller des modules de contrôle MOS contre cette plaque pour adresser les zones pixels d'affichage 102.

Après le dépôt des modules RVB, il est possible de communiquer avec le module souhaité ou imposer une configuration (par exemple par laser qui brule des fusibles) afin de forcer un des modules à n'afficher que l'une des couleurs souhaitée. Ceci combiné à une structuration des éléments conducteurs d'alimentation électrique permet d'avoir un dispositif d'affichage 100 de grande surface et potentiellement reconfigurable sur une techno grande surface type TFT tout en ne fabriquant / déposant qu'un seul type de module RVB.

Un contrôleur peut gérer les signaux d'alimentation, les courants ou les tensions de plusieurs zones pixel d'affichage réalisant chacune une émission lumineuse RVB. Ce contrôleur peut recevoir ses données par liaison filaire ou RF, et distribuer les informations par zone pixel d'affichage. Cette solution offre l'avantage d'avoir un contrôleur CMOS très petit par rapport à la surface occupée par les zones pixel d'affichage contrôlée.

On décrit maintenant différents modes de réalisation du dispositif d'affichage 100 selon l'invention telle que revendiquée, dans lequel les modules LEDs 104 communiquent par signaux RF.

On se réfère tout d'abord à la figure 21 qui représente schématiquement une partie d'un tel dispositif d'affichage 100.

Ce dispositif 100 comporte un plan d'affichage sur lequel une ou plusieurs images sont destinées à être affichées. Ce plan d'affichage est divisé en plusieurs zones pixel d'affichage 102 contrôlées indépendamment les unes des autres.

Chaque zone pixel d'affichage 102 comporte un ou plusieurs modules LED 104. Chaque module LED 104 comporte au moins une LED 105, qui est ici un µLED. Les LED 105 comportent chacune une jonction p-n formée par des couches de GaN et/ou d'InGaN et/ou d'AlGaN.

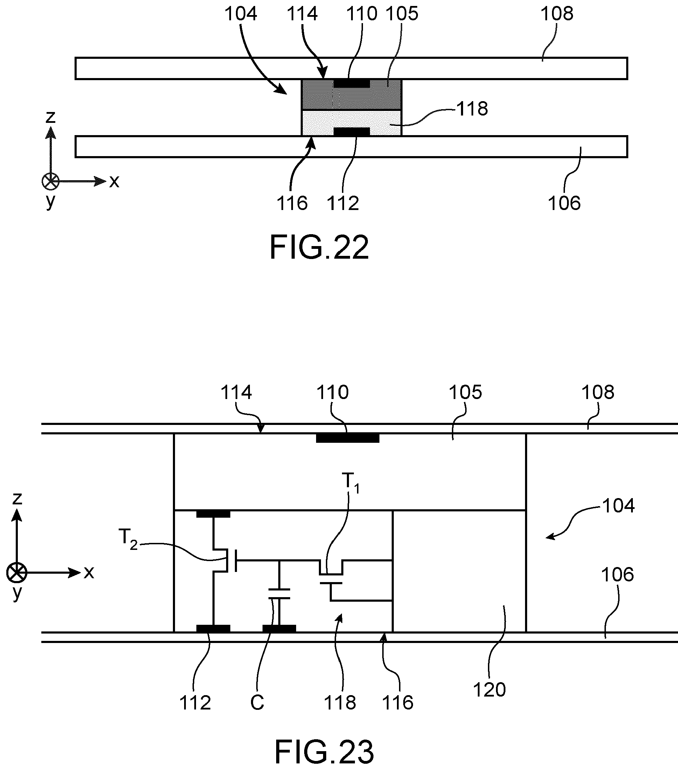

Les modules LED 104 sont interposés entre deux éléments conducteurs d'alimentation électrique 106, 108 (référencés 106.1 à 106.6 et 108.1 à 108.8 sur la figure 21), et chaque module LED 104 comporte deux plots d'alimentation électrique 110, 112 disposés au niveau de deux faces opposées 114, 116 du module LED 104 dont l'une correspond à une face émissive de la LED 105 dudit module LED 104 et reliés respectivement à l'un et l'autre des deux éléments conducteurs d'alimentation électrique 106, 108 sur lesquels sont appliqués un potentiel d'alimentation (sur l'élément 106 dans cet exemple) et un potentiel de référence (sur l'élément 108 dans cet exemple). Cette configuration d'un des modules LED 104 est visible sur la figure 22. Dans cet exemple, la face émissive de la LED 105 correspond à la face 114 qui se trouve du côté de l'élément conducteur 108.

A titre d'exemple, l'élément conducteur 108 qui est disposé contre la face émissive des LEDs 105 peut comporter un matériau conducteur transparent tel que de l'ITO.

Sur la figure 21, les conducteurs d'alimentation électrique 106, 108 sont réalisés sous la forme de pistes conductrices disposées perpendiculairement les unes des autres. Dans le mode de réalisation selon l'invention décrit ici, chaque intersection d'un des éléments conducteurs 106 agencé en ligne avec un des éléments conducteurs 108 agencé en colonne définit une zone pixel d'affichage. Cet agencement forme ainsi une matrice de zones pixel d'affichage 102. En outre, en commandant les modules LED 104 tels que le ou les modules LED 104 de chaque zone 102 à partir d'un même signal, c'est-à-dire tels qu'ils affichent un signal lumineux formant un même point image, chaque zone pixel 102 correspond donc à un pixel du plan d'affichage du dispositif 100.

Ici, chaque module LED 104 comporte également un circuit de commande 118. Ce circuit de commande 118 comporte des éléments électroniques permettant de commander l'émission lumineuse réalisée par la LED 105 du module 104 en délivrant à la LED 105 un signal représentatif du signal lumineux à émettre.

Un exemple de réalisation d'un tel circuit de commande 118 est représenté schématiquement sur la figure 23. Ce circuit 116 comporte un premier transistor T1 servant à commander l'allumage ou l'extinction de la LED 105, un transistor T2 permettant d'injecter le courant souhaité dans la LED 105 et une capacité C de stockage permettant de maintenir la tension souhaitée sur la grille du transistor T2. Une tension Vdd issue de l'élément conducteur 106 est appliquée sur le drain du transistor T2 depuis le plot d'alimentation électrique 112 du module LED 104 en contact avec l'élément conducteur 106. Le courant délivré par le transistor T2 est appliqué sur l'une des couches de la jonction p-n de la LED 105. L'autre couche de la jonction p-n de la LED 105 est soumise au potentiel électrique transmis par l'élément conducteur 108 via le plot d'alimentation électrique 110.

Des signaux de commande sont transmis au circuit de commande 118 depuis un dispositif de contrôle 120. Dans ce mode de réalisation, chaque module LED 104 comporte un dispositif de contrôle 120 destiné à contrôler le signal lumineux destiné à être émis par ce module LED 104. Le dispositif de contrôle 120 peut comprendre des circuits électroniques tels qu'une mémoire, un décodeur de message reçu, une unité de séquencement des commandes à appliquer par le circuit de commande 118, etc... Le dispositif de contrôle 120 est avantageusement alimenté via des connexions reliées aux éléments conducteurs 106 et 108.

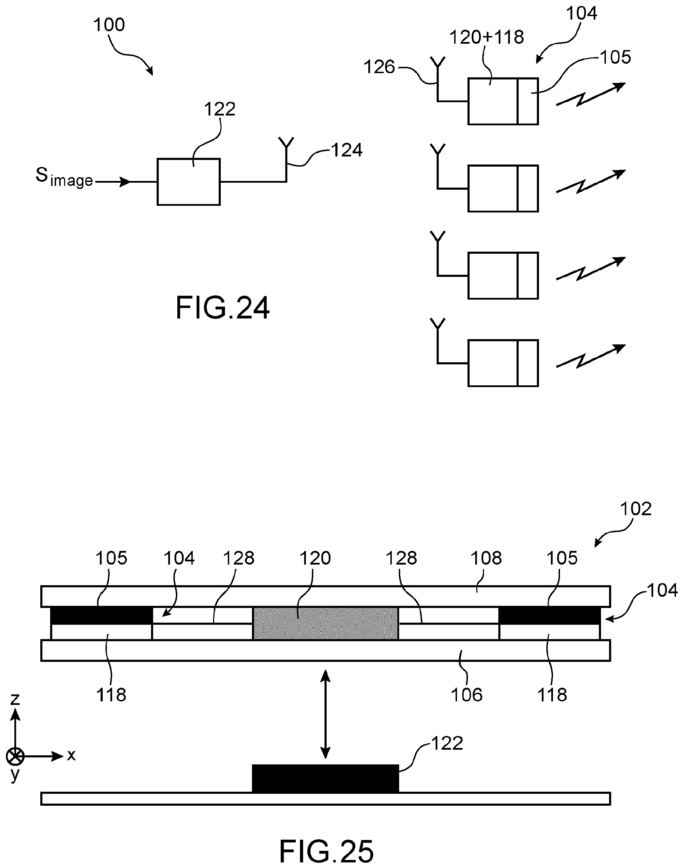

Ensuite, le dispositif 100 comporte une interface d'entrée/sortie apte à recevoir en entrée un signal d'image S_{image} destiné à être affiché par le dispositif 100. Cette interface d'entrée/sortie comprend une ou plusieurs unités de commande 122, représentée(s) en figure 24, qui, à partir du signal image S_{image} ou d'une partie de ce signal S_{image}, détermine(nt) les signaux de commande à envoyer aux différentes zones pixel d'affichage 102 pour que les LEDs 105 émettent des signaux lumineux correspondant ensemble au signal image S_{image}.

Contrairement aux écrans classiques dans lesquels ces signaux de commande sont transmis depuis l'élément de l'écran recevant le signal d'image à afficher sur l'écran jusqu'au circuit de commande de chaque pixel par l'intermédiaire de connexions filaires, la ou chacune des unités de commande 122 du dispositif 100 transmet les signaux de commande des zones de pixel d'affichage 102 aux dispositifs de contrôle 120 par ondes RF, sans fil, via au moins une première antenne 124. Ces signaux de commande sont reçus par des deuxièmes antennes 126 chacune couplée à un des dispositifs de contrôle 120. Ainsi, dans le mode de réalisation décrit ici, du fait que chaque module LED 104 est muni de son propre dispositif de contrôle 120, chaque module LED 104 comporte une antenne 126 permettant de recevoir le signal de commande qui permettra, après un traitement réalisé par un circuit de traitement de signal RF inclus dans le dispositif de contrôle 120, d'obtenir l'émission lumineuse souhaitée pour la LED 105 de ce module LED 104 (voir le schéma de la figure 24).

De façon générale, les signaux de commande propagés par voie RF peuvent comprendre différents types d'informations, par exemple un identifiant du dispositif de contrôle 120 destinataire ou un niveau de luminosité souhaité pour une zone pixel d'affichage 102 destinataire. Le signal de commande peut également comprendre une séquence, temporelle, de niveaux de luminosité souhaités. Les informations transitant par voie RF peuvent éventuellement être codées. Le dispositif de contrôle 120 destinataire pourra, le cas échéant, décoder les informations et par suite piloter le circuit de commande de sorte à obtenir le niveau de luminosité souhaité, ou la séquence souhaitée. Les informations sur le ou les niveaux de luminosité souhaités peuvent être mémorisés dans une mémoire du dispositif de contrôle 120 et ces informations peuvent, par exemple, être mises à jour uniquement en cas de besoin de changement de valeurs de luminosité souhaitées.

Bien que sur la figure 24, une seule antenne 124 soit représentée, il est possible d'avoir plusieurs unités de commande 122 chacune reliée à une antenne 124 et destiné à transmettre par RF les signaux de commande d'une partie seulement des zones pixel d'affichage du dispositif 100. Il est par exemple possible d'avoir plusieurs unités de commande 122 reliées chacune à une antenne 124 distincte, ces unités de commande et ces antennes 124 étant espacées les unes des autres d'une distance égale à environ 300 µm, avec chacune de ces unités de commande 122 et de ces antennes 124 gérant les transmissions RF au sein du dispositif 100 dans une région formant un carré de dimensions 300 µm x 300 µm.

Dans le mode de réalisation décrit ci-dessus, chaque zone de pixel d'affichage 102 comporte un module LED 104 comportant par exemple une LED 105 de type monochrome. En variante, le module LED 104 pourrait inclure 3 LED, par exemple RVB, pour Rouge/Vert/Bleu.

En variante, chaque zone de pixel d'affichage 102 peut comporter plusieurs modules LED 104 destinés à afficher le même signal lumineux.

En variante, chaque zone de pixel d'affichage peut comporter plusieurs modules LED 104 monochromes et par exemple au moins trois modules LED 104 aptes à émettre respectivement des couleurs rouge, vert et bleu. Dans ce cas, les signaux lumineux émis par chacune des diodes monochromes de couleurs différentes peuvent être définis à partir d'un même signal de commande (qui peut demander un même niveau de courant dans toutes les LEDs ou demander des niveaux de courants différentes dans les LEDS) ou à partir de signaux de commande différents destinés à chacune des couleurs de LED de la zone pixel d'affichage.

Dans le mode de réalisation décrit ci-dessus, chacun des modules LED 104 comporte un dispositif de contrôle 120 couplé à une antenne 126.

Selon un autre mode de réalisation, il est possible que chaque dispositif de contrôle 120, ainsi que chaque antenne 126, soit associé à plusieurs modules LED 104. Sur la figure 25, une zone de pixel d'affichage 102 du dispositif 100 est représentée. Cette zone inclut plusieurs modules LED 104 couplés de manière filaire (fils référencés 128) avec un dispositif de contrôle 120 commun à ces différents modules 104. L'unité de commande 122 associé à cette zone 102 envoie donc les différents signaux de commande de ces modules LED 104 par transmission RF au dispositif de contrôle 120 qui les transmet ensuite par connexions filaires aux modules 104.

Dans l'exemple représenté sur la figure 25, le dispositif de contrôle est disposé entre les éléments conducteurs 106, 108, comme les modules LED 104.

Cet autre mode de réalisation est par exemple utilisé lorsque la densité des modules LED 104 ne permet pas à chaque module LED 104 de posséder sa propre antenne 126, en raison notamment des dimensions de ces antennes 126 imposées par les caractéristiques des signaux transmis.

En outre, le dispositif de contrôle 120 peut réaliser le pilotage des modules LED 104 à partir des signaux reçus sur la deuxième antenne même lorsque les modules LED ne comportent pas de circuits de commande.

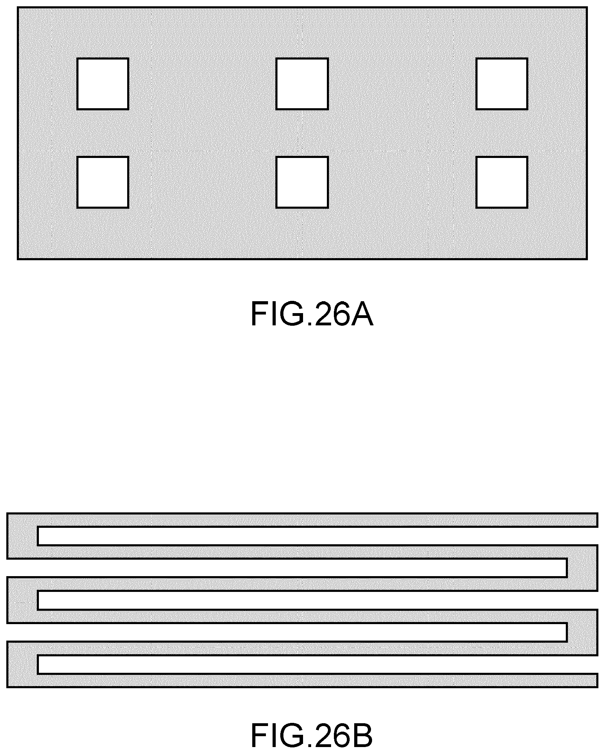

Dans les modes de réalisation décrits ci-dessus, les antennes 126 peuvent être disposées dans un même plan que l'un des deux éléments conducteurs 106, 108 (dans un même plan que l'élément conducteur 106 dans les exemples de réalisation précédemment décrits). Dans ce cas, les antennes 126 peuvent être réalisées sous la forme d'antennes planaires, ou « patch », ajourées (exemple représenté sur la figure 26A) ou sous forme de lignes espacées (exemple représenté sur la figure 26B).

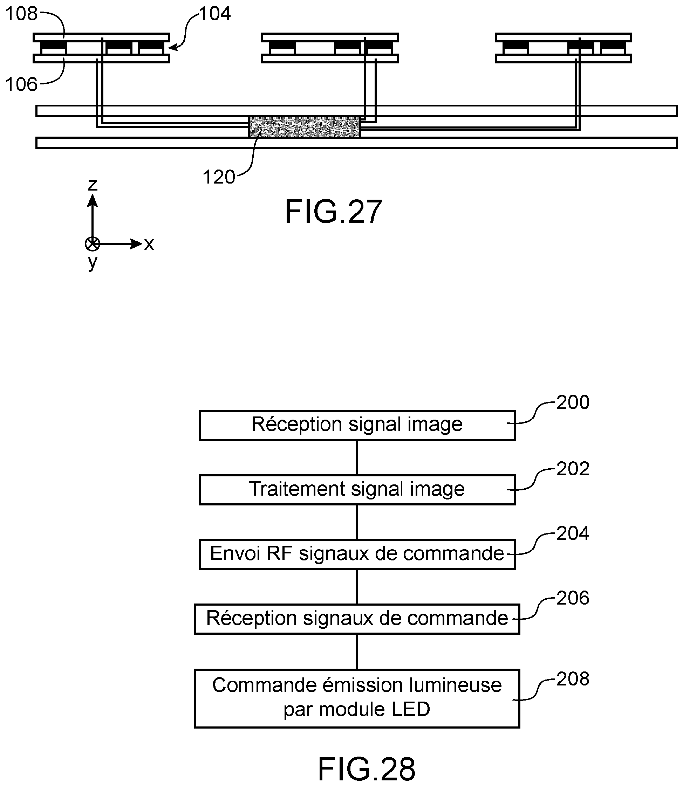

Selon un exemple comparatif, ne faisant pas partie de l'invention telle que revendiquée, représenté sur la figure 27, il est également possible d'avoir les dispositifs de contrôle 120 qui ne soient pas disposés dans le plan d'affichage avec les modules LED 104, mais qui soient disposés derrière ce plan d'affichage, avec dans ce cas des liaisons filaires entre ces dispositifs de contrôle 120 et les modules LED 104.

Selon une variante de réalisation, il est possible que les modules LED 104 ne soient pas alimentés électriquement par l'intermédiaire des éléments conducteurs 106, 108, mais soient télé-alimentés en utilisant par exemple une communication de type RFID ou NFC.

Dans les exemples de réalisation précédemment décrits, les éléments conducteurs 106, 108 correspondent chacun à plusieurs pistes conductrices s'étendant selon des directions différentes. En variante, il est possible que les éléments conducteurs 106, 108 correspondent chacun à un plan conducteur commun à tous les modules LED 104 ou commun à un sous-ensemble de modules LED 104 du dispositif 100.

Les communications RF précédemment décrites peuvent faire appel à des codes d'identification associés à chaque module LED 104 ou à des groupes de modules LED 104, par exemple ceux d'une même zone pixel d'affichage 102.

Un organigramme du procédé d'affichage mis en œuvre par le dispositif 100 est représenté sur la figure 28.

A une étape 200, le signal d'image destinée à être affichée sur le plan d'affichage du dispositif 100 est reçu par le dispositif 100 via son interface d'entrée/sortie.

A une étape 202, le signal d'image reçu est traité par la ou les unités de commande 122 qui déterminent les signaux de commande à envoyer aux différentes zones pixel d'affichage 102 du dispositif 100.

A une étape 204, les signaux de commande calculés par la ou les unités de commande 122 sont envoyés aux zones pixel d'affichage 102 par ondes RF via la ou les antennes 124.

A une étape 206, les signaux de commande sont reçus, via la ou les antennes 126, par le ou les dispositifs de contrôle 120 présents dans chaque zone pixels d'affichage 102 adressée par la ou les unités de commande 122.

A une étape 208, les modules LED 104 sont alors commandés par les dispositifs de contrôle 120 pour afficher les signaux lumineux correspondant aux signaux de commande qui leur ont été transmis.

L'homme de l'art pourra envisager d'autres modes de réalisation de la présente invention. Entre autre, bien que les modes de réalisation décrits précédemment comportent des modules LED chacun disposé entre deux éléments conducteurs d'alimentation, il est tout à fait possible d'envisager un dispositif d'affichage selon un exemple comparatif, ne faisant pas partie de l'invention telle que revendiquée, dans lequel les deux éléments conducteurs sont positionnés sur un même substrat, du même côté des modules LED (un exemple de réalisation d'un tel dispositif d'affichage est décrit dans la demande de brevet français FR 3 044 467 A1).

## Revendications

1. Dispositif d'affichage (100) comprenant au moins :
- un support (130) ;
- des premier et deuxième éléments conducteurs d'alimentation électrique (106, 108), ledit au moins un premier élément conducteur (108) étant placé sur une face dudit support (130) ;
- plusieurs modules LED (104) comportant chacun au moins une LED (105), chaque LED comportant au moins deux couches (134, 136) formant une jonction p-n, chaque module LED comprenant deux plots d'alimentation électrique (110, 112) disposés respectivement sur deux faces opposées du module LED dont l'une correspond à une face émissive de la LED dudit module LED ;
- un plan d'affichage comprenant plusieurs zones pixel d'affichage (102), chaque zone pixel d'affichage (102) comprenant au moins un des modules LED (104) et un dispositif de contrôle (120) dudit au moins un des modules LED (104) de ladite zone pixel d'affichage (102), ledit au moins un des modules LED (104) étant destiné à réaliser un affichage d'un point lumineux du dispositif d'affichage en fonction d'un signal de commande de ladite zone pixel d'affichage (102) destiné à être reçu par le dispositif de contrôle (120) dudit au moins un des modules LED, chaque module LED (104) comprenant son propre dispositif de contrôle (120) destiné à contrôler un signal lumineux émis par ledit module LED, ou plusieurs modules LED (104) d'une même zone de pixel d'affichage (102) étant couplés de manière filaire avec le dispositif de contrôle (120), commun à ces différents modules (104) ;
- une interface d'entrée/sortie du dispositif d'affichage (100), apte à recevoir un signal d'image destinée à être affichée sur le plan d'affichage et comprenant au moins une unité de commande (122) destinée à délivrer les signaux de commande des zones pixel d'affichage (102) ;
dans lequel :
- les plots d'alimentation électrique (110, 112) de chaque module LED (104) sont reliés respectivement aux premier et deuxième éléments conducteurs d'alimentation électrique (106, 108), pour l'alimentation électrique du module LED ;
- le rapport de dimensions entre une surface d'accueil d'une des zones pixel d'affichage, formée par le premier élément conducteur (108), et la surface de connexion d'un des deux plots d'alimentation électrique (110) d'un des modules LED avec le premier élément conducteur (108) est supérieur ou égal à 2 ;
- l'unité de commande (122) est reliée à au moins une première antenne (124) apte à émettre par ondes RF les signaux de commande des zones pixel d'affichage (102) ;
- chaque dispositif de contrôle (120) comprend au moins une deuxième antenne (126) couplée à un circuit de traitement de signal RF et est apte à recevoir le signal de commande de la zone pixel d'affichage (102) associée et à commander ledit au moins un des modules LED (104) de la zone pixel d'affichage (102) en fonction du signal de commande reçu pour émettre un signal lumineux correspondant à une partie du signal image associée à ladite zone pixel d'affichage (102).

2. Dispositif d'affichage (100) selon la revendication 1, dans lequel les modules LED (104) sont répartis de manière aléatoire, de sorte que la densité de modules LED sur la surface d'accueil est non uniforme.

3. Dispositif d'affichage (100) selon l'une des revendications précédentes, dans lequel chaque module LED (104) comporte en outre un circuit de commande (118) de la LED (105) dudit module LED (104), le circuit de commande (118) étant apte à délivrer, sur une des couches de la jonction p-n de la LED (105), un signal représentatif du signal lumineux destiné à être émis par la LED (105).

4. Dispositif d'affichage (100) selon la revendication 3, dans lequel chaque module LED (104) comprend le dispositif de contrôle (120), dans lequel les circuits de commande (118) sont aptes réaliser une démodulation d'un signal binaire représentatif du signal lumineux .

5. Dispositif d'affichage (100) selon la revendication 4, dans lequel la démodulation est de type Pulse Width Modulation, PWM, ou Binary Code Modulation, BCM.

6. Dispositif d'affichage (100) selon l'une des revendications précédentes, dans lequel chacun des premier et deuxième éléments conducteurs d'alimentation électrique (106, 108) comporte plusieurs pistes conductrices s'étendant sensiblement parallèlement les unes des autres, les pistes conductrices du premier élément conducteur d'alimentation électrique s'étendant sensiblement perpendiculairement aux pistes conductrices du deuxième élément conducteur d'alimentation électrique.

7. Dispositif d'affichage (100) selon l'une des revendications 1 à 5, dans lequel chacun des premier et deuxième éléments conducteurs d'alimentation électrique (106, 108) comporte une unique couche électriquement conductrice.

8. Dispositif d'affichage (100) selon l'une des revendications précédentes, dans lequel chaque dispositif de contrôle (120) est associé à plusieurs modules LED (104).

9. Dispositif d'affichage (100) selon l'une des revendications précédentes, dans lequel chaque module LED (104) chaque module LED (104) comprend le dispositif de contrôle (120) et comporte deux LED disposées tête-bêche l'une à côté de l'autre.

10. Procédé de réalisation d'un dispositif d'affichage (100) comprenant au moins :
- réalisation de plusieurs modules LED (104) comportant chacun au moins une LED (105) comprenant au moins deux couches (134, 136) formant une jonction p-n, au moins deux plots d'alimentation électrique (110, 112) disposés respectivement au niveau de deux faces opposées du module LED dont l'une correspond à une face émissive de la LED dudit module LED ;
- réalisation d'un support (130) avec au moins un premier élément conducteur d'alimentation électrique (108) placé sur une face du support ;
- report des modules LED sur le support tel que le premier élément conducteur d'alimentation électrique forme, pour au moins une partie des modules LED, au moins une surface d'accueil d'au moins une zone pixel d'affichage d'un plan d'affichage, ledit plan d'affichage comprenant plusieurs zones pixel d'affichage (102), chaque zone pixel d'affichage (102) comprenant au moins un des modules LED (104) et un dispositif de contrôle (120) dudit au moins un des modules LED (104) de ladite zone pixel d'affichage (102), ledit au moins un des modules LED (104) étant destiné à réaliser un affichage d'un point lumineux du dispositif d'affichage en fonction d'un signal de commande de ladite zone pixel d'affichage (102) destiné à être reçu par le dispositif de contrôle (120) dudit au moins un des modules LED, dans lequel soit chaque module LED (104) comprend son propre dispositif de contrôle (120) destiné à contrôler un signal lumineux émis par ledit module LED, soit plusieurs modules LED (104) d'une même zone de pixel d'affichage (102) sont couplés de manière filaire avec le dispositif de contrôle (120), commun à ces différents modules (104), tel que l'un des plots d'alimentation électrique de chacun desdits modules LED soit disposé contre ladite surface d'accueil pour réaliser un contact électrique, le rapport de dimensions entre ladite surface d'accueil et la surface de connexion d'un des deux plots d'alimentation électrique (110) d'un des modules LED avec le premier élément conducteur (108) est supérieur ou égal à 2 ;
- réalisation d'au moins un deuxième élément conducteur d'alimentation électrique sur les modules LED tel que les modules LED soient disposés entre les premier et deuxième éléments conducteurs d'alimentation électrique et que les deux plots d'alimentation électrique soient reliés respectivement aux premier et deuxième éléments conducteurs d'alimentation électrique ;
- réalisation d'une interface d'entrée/sortie du dispositif d'affichage (100), apte à recevoir un signal d'image destinée à être affichée sur le plan d'affichage et comprenant au moins une unité de commande (122) destinée à délivrer les signaux de commande des zones pixel d'affichage (102) et reliée à au moins une première antenne (124) apte à émettre par ondes RF les signaux de commande des zones pixel d'affichage (102) ;
et dans lequel chaque dispositif de contrôle (120) est réalisé tel qu'il comprend au moins une deuxième antenne (126) couplée à un circuit de traitement de signal RF et est apte à recevoir le signal de commande de la zone pixel d'affichage (102) associée et à commander ledit au moins un des modules LED (104) de la zone pixel d'affichage (102) en fonction du signal de commande reçu pour émettre un signal lumineux correspondant à une partie du signal image associée à ladite zone pixel d'affichage (102).

11. Procédé selon la revendication 10, dans lequel chaque module LED (104) comprend le dispositif de contrôle (120), et dans lequel, lors de l'étape de report des modules LED, le positionnement des modules LED est réalisé de façon aléatoire ou quasi-aléatoire sur ladite au moins une surface d'accueil du premier élément conducteur.

12. Procédé selon la revendication 11, dans lequel la dispersion des modules LED (104) sur le support d'accueil (130) est aléatoire et comporte une projection par spray des modules LED, ou une mise en suspension des modules LED dans une solution puis une sédimentation des modules LED sur le support d'accueil et un retrait du milieu de la solution dans lequel les modules LED ont été dispersés.

13. Procédé selon la revendication 11, dans lequel le report des modules LED (104) est mis en œuvre de façon pseudo-aléatoire en utilisant une machine de transfert apte à reporter simultanément plusieurs modules LED sur une partie du support d'accueil.

14. Procédé selon l'une des revendications 10 à 13, dans lequel la réalisation de chacun des premier et deuxième éléments conducteurs d'alimentation électrique (106, 108) comporte le dépôt par impression de plusieurs pistes conductrices s'étendant sensiblement parallèlement les unes des autres, les pistes conductrices d'un premier des deux éléments conducteurs d'alimentation électrique s'étendant sensiblement perpendiculairement aux pistes conductrices d'un deuxième des deux éléments conducteurs d'alimentation électrique.

15. Procédé selon l'une des revendications 10 à 14, comportant en outre, entre le report des modules LED (104) et la réalisation du deuxième élément conducteur d'alimentation électrique (106), la mise en œuvre des étapes suivantes :
- dépôt d'une résine photosensible (132) recouvrant les modules LED et les parties du support d'accueil se trouvant du côté des modules LED et non recouvertes par les modules LED ;
- insolation de la résine sensible à travers le support d'accueil qui est transparent vis-à-vis de la longueur d'onde utilisée pour cette insolation ;
- développement de la résine insolée tel que des parties restantes insolées de la résine photosensible soient conservées entre les modules LED et forment des éléments de passivation entre les modules LED.

16. Procédé selon l'une des revendications 11 à 13, dans lequel les modules LED sont réalisés tels qu'ils comportent chacun au moins un micro-aimant et/ou tels que des faces latérales des modules LED soient gravées telles que, lors de la dispersion des modules LED sur le support d'accueil, une disposition des modules LED telle que la face émissive de la LED soit disposée d'un côté du support d'accueil qui est optiquement transparent soit favorisée.

17. Dispositif d'affichage (100) selon la revendication 1, dans lequel les modules LED (104) sont répartis de manière aléatoire ou quasi-aléatoire sur la surface d'accueil du premier élément conducteur (108), le dispositif résultant de la mise en œuvre du procédé selon la revendication 11.

## Patentansprüche

1. Anzeigevorrichtung (100), mindestens umfassend:
- einen Träger (130);
- ein erstes und ein zweites elektrisch leitfähiges Element (106, 108), wobei das mindestens eine erste leitfähige Element (108) auf einer Seite des Trägers (130) platziert ist;
- mehrere LED-Module (104), die jeweils mindestens eine LED (105) aufweisen, wobei jede LED mindestens zwei Schichten (134, 136) aufweist, die eine p-n-Verbindung bilden, wobei jedes LED-Modul zwei Stromversorgungsstifte (110, 112) umfasst, die jeweils auf zwei gegenüberliegenden Seiten des LED-Moduls angeordnet sind, von denen eine einer Emissionsseite der LED des LED-Moduls entspricht;
- eine Anzeigeebene, die mehrere Anzeigepixelbereiche (102) umfasst, wobei jeder Anzeigepixelbereich (102) mindestens eines der LED-Module (104) und eine Steuervorrichtung (120) des mindestens einen der LED-Module (104) des Anzeigepixelbereichs (102) umfasst, wobei das mindestens eine der LED-Module (104) dazu bestimmt ist, eine Anzeige eines Lichtpunkts der Anzeigevorrichtung in Abhängigkeit von einem Steuersignal des Anzeigepixelbereichs (102) herzustellen, der von der Steuervorrichtung (120) des mindestens einen der LED-Module empfangen werden soll, wobei jedes LED-Modul (104) eine eigene Steuervorrichtung (120) umfasst, die dazu bestimmt ist, ein von dem LED-Modul gesendetes Lichtsignal zu steuern, oder mehrere LED-Module (104) eines gleichen Anzeigepixelbereichs (102) drahtgebunden mit der Steuervorrichtung (120) gekoppelt sind, die diesen verschiedenen Modulen (104) gemeinsam ist;
- eine Eingangs-/Ausgangsschnittstelle der Anzeigevorrichtung (100), die dazu ausgelegt ist, ein Bildsignal zu empfangen, das auf der Anzeigeebene angezeigt werden soll, und mindestens eine Steuereinheit (122) umfasst, die dazu bestimmt ist, die Steuersignale der Anzeigepixelbereiche (102) zu liefern;
wobei:
- die Stromversorgungsstifte (110, 112) jedes LED-Moduls (104) zur Stromversorgung des LED-Moduls jeweils mit dem ersten und dem zweiten elektrisch leitfähigen Element (106, 108) verbunden sind;
- das Maßverhältnis zwischen einer Aufnahmefläche eines der Anzeigepixelbereiche, die durch das erste leitfähige Element (108) gebildet wird, und der Verbindungsfläche eines der beiden Stromversorgungsstifte (110) eines der LED-Module mit dem ersten leitfähigen Element (108) größer oder gleich 2 ist;
- die Steuereinheit (122) mit mindestens einer ersten Antenne (124) verbunden ist, die dazu ausgelegt ist, die Steuersignale der Anzeigepixelbereiche (102) über HF-Wellen zu senden;
- jede Steuervorrichtung (120) mindestens eine zweite Antenne (126) umfasst, die mit einer HF-Signalverarbeitungsschaltung gekoppelt ist und dazu ausgelegt ist, das Steuersignal des zugehörigen Anzeigepixelbereichs (102) zu empfangen und das mindestens eine der LED-Module (104) des Anzeigepixelbereichs (102) in Abhängigkeit vom empfangenen Steuersignal zu steuern, um ein Lichtsignal zu senden, das einem Teil des Bildsignals entspricht, das mit dem Anzeigepixelbereich (102) verbunden ist.

2. Anzeigevorrichtung (100) nach Anspruch 1, wobei die LED-Module (104) zufällig verteilt sind, so dass die LED-Moduldichte auf der Aufnahmefläche ungleichmäßig ist.

3. Anzeigevorrichtung (100) nach einem der vorhergehenden Ansprüche, wobei jedes LED-Modul (104) weiter einen Steuerkreis (118) der LED (105) des LED-Moduls (104) aufweist, wobei der Steuerkreis (118) dazu ausgelegt ist, auf einer der Schichten der p-n-Verbindung der LED (105) ein Signal zu liefern, das für das von der LED (105) zu sendende Lichtsignal repräsentativ ist.

4. Anzeigevorrichtung (100) nach Anspruch 3, wobei jedes LED-Modul (104) die Steuervorrichtung (120) umfasst, wobei die Steuerkreise (118) dazu ausgelegt sind, eine Demodulation eines für das Lichtsignal repräsentativen Binärsignals herzustellen.

5. Anzeigevorrichtung (100) nach Anspruch 4, wobei die Demodulation vom Typ Pulsweitenmodulation, PWM, oder Binärcodemodulation, BCM, ist.

6. Anzeigevorrichtung (100) nach einem der vorhergehenden Ansprüche, wobei jedes des ersten und des zweiten elektrisch leitfähigen Elements (106, 108) mehrere sich im Wesentlichen parallel zueinander erstreckende Leiterbahnen aufweist, wobei sich die Leiterbahnen des ersten elektrisch leitfähigen Elements im Wesentlichen senkrecht zu den Leiterbahnen des zweiten elektrisch leitfähigen Elements erstrecken.

7. Anzeigevorrichtung (100) nach einem der Ansprüche 1 bis 5, wobei jedes des ersten und des zweiten elektrisch leitfähigen Elements (106, 108) eine einzige elektrisch leitfähige Schicht aufweist.

8. Anzeigevorrichtung (100) nach einem der vorhergehenden Ansprüche, wobei jede Steuervorrichtung (120) mit mehreren LED-Modulen (104) verbunden ist.

9. Anzeigevorrichtung (100) nach einem der vorhergehenden Ansprüche, wobei jedes LED-Modul (104) jedes LED-Modul (104) die Steuervorrichtung (120) umfasst und zwei nebeneinander angeordnete LEDs aufweist.

10. Verfahren zum Herstellen einer Anzeigevorrichtung (100), umfassend mindestens:
- Herstellen mehrerer LED-Module (104), die jeweils mindestens eine LED (105), die mindestens zwei Schichten (134, 136) umfasst, die eine p-n-Verbindung bilden, und mindestens zwei Stromversorgungsstifte (110, 112) aufweisen, die jeweils an zwei gegenüberliegenden Seiten des LED-Moduls angeordnet sind, von denen eine einer Emissionsseite der LED des LED-Moduls entspricht;
- Herstellen eines Trägers (130) mit mindestens einem ersten elektrisch leitfähigen Element (108), das auf einer Seite des Trägers platziert ist;
- Übertragen der LED-Module auf den Träger, so dass das erste elektrisch leitfähige Element für mindestens einen Teil der LED-Module mindestens eine Aufnahmefläche von mindestens einem Anzeigepixelbereich einer Anzeigeebene bildet, wobei die Anzeigeebene mehrere Anzeigepixelbereiche (102) umfasst, wobei jeder Anzeigepixelbereich (102) mindestens eines der LED-Module (104) und eine Steuervorrichtung (120) des mindestens einen der LED-Module (104) des Anzeigepixelbereichs (102) umfasst, wobei das mindestens eine der LED-Module (104) dazu bestimmt ist, eine Anzeige eines Lichtpunkts der Anzeigevorrichtung in Abhängigkeit von einem Steuersignal des Anzeigepixelbereichs (102) herzustellen, das von der Steuervorrichtung (120) des mindestens einen der LED-Module empfangen werden soll, wobei entweder jedes LED-Modul (104) eine eigene Steuervorrichtung (120) umfasst, die dazu bestimmt ist, ein von dem LED-Modul gesendetes Lichtsignal zu steuern, oder mehrere LED-Module (104) eines gleichen Anzeigepixelbereichs (102) drahtgebunden mit der Steuervorrichtung (120), die diesen verschiedenen Modulen (104) gemeinsam ist, gekoppelt sind, sodass einer der Stromversorgungsstifte jedes der LED-Module gegen die Aufnahmefläche angeordnet ist, um einen elektrischen Kontakt herzustellen, wobei das Maßverhältnis zwischen der Aufnahmefläche und der Verbindungsfläche eines der beiden Stromversorgungsstifte (110) eines der LED-Module mit dem ersten leitfähigen Element (108) größer oder gleich 2 ist;
- Herstellen mindestens eines zweiten elektrisch leitfähigen Elements an den LED-Modulen, sodass die LED-Module zwischen dem ersten und dem zweiten elektrisch leitfähigen Element angeordnet sind und die beiden elektrisch leitfähigen Elemente jeweils mit dem ersten und dem zweiten elektrisch leitfähigen Element verbunden sind;
- Herstellen einer Eingangs-/Ausgangsschnittstelle der Anzeigevorrichtung (100), die dazu ausgelegt ist, ein Bildsignal zu empfangen, das auf der Anzeigeebene angezeigt werden soll, und die mindestens eine Steuereinheit (122) umfasst, die dazu bestimmt ist, die Steuersignale der Anzeigepixelbereiche (102) zu liefern, und die mit mindestens einer ersten Antenne (124) verbunden ist, die dazu ausgelegt ist, die Steuersignale der Anzeigepixelbereiche (102) über HF-Wellen zu senden;
und wobei jede Steuervorrichtung (120) so hergestellt ist, dass sie mindestens eine zweite Antenne (126) umfasst, die mit einer HF-Signalverarbeitungsschaltung gekoppelt ist und dazu ausgelegt ist, das Steuersignal des zugehörigen Anzeigepixelbereichs (102) zu empfangen und das mindestens eine der LED-Module (104) des Anzeigepixelbereichs (102) in Abhängigkeit vom empfangenen Steuersignal zu steuern, um ein Lichtsignal zu senden, das einem Teil des Bildsignals entspricht, das mit dem Anzeigepixelbereich (102) verbunden ist.

11. Verfahren nach Anspruch 10, wobei jedes LED-Modul (104) die Steuervorrichtung (120) umfasst, und wobei beim Schritt des Übertragens der LED-Module die Positionierung der LED-Module zufällig oder nahezu zufällig auf der mindestens einen Aufnahmefläche des ersten leitfähigen Elements erfolgt.

12. Verfahren nach Anspruch 11, wobei das Dispergieren der LED-Module (104) auf dem Aufnahmeträger (130) zufällig ist und ein Aufsprühen der LED-Module oder ein Suspendieren der LED-Module in einer Lösung und anschließendes Sedimentieren der LED-Module auf dem Aufnahmeträger und Entfernen des Mediums aus der Lösung, in dem die LED-Module dispergiert wurden, aufweist.

13. Verfahren nach Anspruch 11, wobei das Übertragen der LED-Module (104) pseudozufällig unter Verwendung einer Übertragungsmaschine durchgeführt wird, die dazu ausgelegt ist, mehrere LED-Module gleichzeitig auf einen Teil des Aufnahmeträgers zu übertragen.

14. Verfahren nach einem der Ansprüche 10 bis 13, wobei das Herstellen jedes des ersten und des zweiten elektrisch leitfähigen Elements (106, 108) das Aufdrucken mehrerer sich im Wesentlichen parallel zueinander erstreckender Leiterbahnen aufweist, wobei die Leiterbahnen eines ersten der beiden elektrisch leitfähigen Elemente sich im Wesentlichen senkrecht zu den Leiterbahnen eines zweiten der beiden elektrisch leitfähigen Elemente erstrecken.

15. Verfahren nach einem der Ansprüche 10 bis 14, das weiter, zwischen dem Übertragen der LED-Module (104) und dem Herstellen des zweiten elektrisch leitfähigen Elements (106), die Durchführung der folgenden Schritte aufweist:
- Ablagern eines lichtempfindlichen Harzes (132), das die LED-Module und die Teile des Aufnahmeträgers abdeckt, die sich auf der Seite der LED-Module befinden und nicht von den LED-Modulen abgedeckt sind;
- Belichten des empfindlichen Harzes durch den Aufnahmeträger, der gegenüber der für diese Belichtung verwendeten Wellenlänge transparent ist;
- Entwickeln des belichteten Harzes, sodass zwischen den LED-Modulen die restlichen belichteten Teile des lichtempfindlichen Harzes erhalten bleiben und Passivierungselemente zwischen den LED-Modulen bilden.

16. Verfahren nach einem der Ansprüche 11 bis 13, wobei die LED-Module so hergestellt sind, dass sie jeweils mindestens einen Mikromagneten aufweisen und/oder dass Seitenflächen der LED-Module so geätzt sind, dass beim Dispergieren der LED-Module auf dem Aufnahmeträger eine Anordnung der LED-Module so begünstigt wird, dass die Emissionsseite der LED auf einer Seite des Aufnahmeträgers angeordnet ist, die optisch transparent ist.

17. Anzeigevorrichtung (100) nach Anspruch 1, wobei die LED-Module (104) zufällig oder nahezu zufällig auf der Aufnahmefläche des ersten leitfähigen Elements (108) verteilt sind, wobei sich die Vorrichtung aus der Durchführung des Verfahrens nach Anspruch 11 ergibt.

## Claims

1. A display device (100) comprising at least:
- a substrate (130);
- first and second electrical supply conductors (106, 108), said at least one first conductor (108) being placed on a face of said substrate (130);
- several LED modules (104) each comprising at least one LED (105), each LED comprising at least two layers (134, 136) forming a p-n junction, each LED module comprising two electrical supply pads (110, 112) respectively disposed on two opposite faces of the LED module, one of which corresponds to an emitting face of the LED of said LED module;
- a display plane comprising a plurality of display pixel areas (102), each display pixel area (102) comprising at least one of the LED modules (104) and a control device (120) for said at least one of the LED modules (104) of said display pixel area (102), said at least one of the LED modules (104) being intended to display a light point of the display device based on a control signal of said display pixel area (102) intended to be received by the control device (120) of said at least one of the LED modules, each LED module (104) comprising its own control device (120) intended to control a light signal emitted by said LED module, or several LED modules (104) of the same display pixel area (102) being coupled by wire to the control device (120) common to said several modules (104);
- an input/output interface of the display device (100), capable of receiving an image signal intended to be displayed on the display plane and comprising at least one control unit (122) intended to deliver the control signals of the display pixel areas (102);
wherein:
- the electrical supply pads (110, 112) of each LED module (104) are respectively connected to the first and second electrical supply conductors (106, 108), for electrically supplying the LED module;
- the ratio of dimensions between a receiving surface of one of the display pixel areas, formed by the first conductor (108), and the connection surface of one of the two electrical supply pads (110) of one of the LED modules with the first conductor (108) is greater than or equal to 2;
- the control unit (122) is connected to at least one first antenna (124) capable of emitting by RF waves the control signals of the display pixel areas (102);
- each control device (120) comprises at least one second antenna (126) coupled to an RF signal processing circuit and is capable of receiving the control signal of the associated display pixel area (102) and to control said at least one of the LED modules (104) of the display pixel area (102) based on the control signal received to emit a light signal corresponding to a part of the image signal associated with said display pixel area (102).

2. The display device (100) according to claim 1, wherein the LED modules (104) are distributed randomly, such that the density of LED modules on the accommodating surface is non-uniform.

3. The display device (100) according to one of the preceding claims, wherein each LED module (104) further comprises a control circuit (118) of the LED (105) of said LED module (104), the control circuit (118) being capable of delivering, on one of the layers of the p-n junction of the LED (105), a signal representative of the light signal intended to be emitted by the LED (105).

4. The display device (100) according to claim 3, wherein each LED module (104) comprises the control device (120), wherein the control circuits (118) are able to perform demodulation of a binary signal representative of the light signal.

5. The display device (100) according to claim 4, wherein the demodulation is of the Pulse Width Modulation, PWM, or Binary Code Modulation, BCM type.

6. The display device (100) according to any one of the preceding claims, wherein each of the first and second electrical supply conductors (106, 108) comprises a plurality of conductive tracks extending substantially parallel to one another, the conductive tracks of the first electrical supply conductor extending substantially perpendicular to the conductive tracks of the second electrical supply conductor.

7. The display device (100) according to any one of claims 1 to 5, wherein each of the first and second electrical supply conductors (106, 108) comprises a single electrically conductive layer.

8. The display device (100) according to one of the preceding claims, wherein each control device (120) is associated with a plurality of LED modules (104).

9. The display device (100) according to any one of the preceding claims, wherein each LED module (104) each LED module (104) comprises the control device (120) and comprises two LEDs arranged top to tail next to each other.

10. A method for making a display device (100) comprising at least:
- making several LED modules (104) each comprising at least one LED (105) comprising at least two layers (134, 136) forming a p-n junction, at least two electrical supply pads (110, 112) respectively disposed at two opposite faces of the LED module, one of which corresponds to an emitting face of the LED of said LED module;
- making a substrate (130) with at least one first electrical supply conductor (108) placed on one face of the substrate;
- transferring the LED modules onto the substrate such that the first electrical supply conductor forms, for at least some of the LED modules, at least one receiving surface for at least one display pixel area of a display plane, said display plane comprising a plurality of display pixel areas (102), each display pixel area (102) comprising at least one of the LED modules (104) and a control device (120) for said at least one of the LED modules (104) in said display pixel area (102), said at least one of the LED modules (104) being intended to display a light point of the display device based on a control signal of said display pixel area (102) intended to be received by the control device (120) of said at least one of the LED modules, wherein either each LED module (104) comprises its own control device (120) intended to control a light signal emitted by said LED module, or multiple LED modules (104) within the same display pixel area (102) are coupled by wire to the control device (120) common to these multiple modules (104), such that one of the electrical supply pads of each of said LED modules is disposed against said receiving surface to establish electrical contact, the dimensions ratio between said receiving surface and the connection surface of one of the two electrical supply pads (110) of one of the LED modules with the first conductor (108) is greater than or equal to 2;
- making at least one second electrical supply conductor on the LED modules such that the LED modules are disposed between the first and second electrical supply conductors and that the two electrical supply pads are connected to the first and second electrical supply conductors respectively;
- making an input/output interface of the display device (100), capable of receiving an image signal intended to be displayed on the display plane and comprising at least one control unit (122) intended to deliver the control signals of the display pixel zones (102) and connected to at least one first antenna (124) capable of emitting by RF waves the control signals of the display pixel zones (102);
and wherein each control device (120) is made such that it comprises at least one second antenna (126) coupled to an RF signal processing circuit and is capable of receiving the control signal of the display pixel zone (102) associated and of controlling said at least one of the LED modules (104) of the display pixel zone (102) according to the control signal received to emit a light signal corresponding to a part of the image signal associated with said display pixel zone (102).

11. The method according to claim 10, wherein each LED module (104) comprises the control device (120), and wherein, during the step of transferring the LED modules, positioning the LED modules is carried out randomly or quasirandomly on said at least one surface of accommodating the first conductive element.

12. The method according to claim 11, wherein LED modules (104) are randomly dispersed on the receiving substrate (130) by spraying the LED modules, or suspending the LED modules in a solution, followed by settling of the LED modules on the receiving substrate and removing the solution in which the LED modules were dispersed.

13. The method according to claim 11, wherein transferring the LED modules (104) is implemented in a pseudo-random manner using a transfer machine capable of simultaneously transferring several LED modules onto part of the accommodating support.

14. The method according to one of claims 10 to 13, wherein making each of the first and second electrical supply conductors (106, 108) comprises printing a plurality of conductive tracks extending substantially parallel to one another, the conductive tracks of a first of the two electrical supply conductors extending substantially perpendicularly to the conductive tracks of a second of the two electrical supply conductors.

15. The method according to one of claims 10 to 14, further comprising, between transferring the LED modules (104) and making the second electrical supply conductor (106), the implementation of the following steps:
- depositing a photosensitive resin (132) covering the LED modules and the parts of the accommodating support located on the side of the LED modules and not covered with the LED modules;
- exposing the sensitive resin through the accommodating support which is transparent with respect to the wavelength used for this exposure;
- developing the resin such that remaining exposed parts of the photosensitive resin are retained between the LED modules and form passivation elements between the LED modules.

16. The method according to one of claims 11 to 13, wherein the LED modules are made such that each one comprises at least one micromagnet and/or such that the side faces of the LED modules are etched such that, when the LED modules are dispersed on the receiving substrate, an arrangement of the LED modules is favored in which the light-emitting face of the LED is disposed on one side of the receiving substrate that is optically transparent.

17. The display device (100) according to claim 1, wherein the LED modules (104) are distributed in a random or quasi-random manner on the accommodating surface of the first conducor (108), the device resulting from the implementation of the method according to claim 11.
